# EUROPEAN PATENT APPLICATION

(11) **EP 2 911 212 A1**
(43) Date of publication of application: **26.08.2015**
(21) Application number: 12886510.2
(22) Date of filing: 18.10.2012
(51) Int. Cl.: H01L 51/42

(54) **PHOTOELECTRIC CONVERSION ELEMENT AND MANUFACTURING METHOD THEREFOR**

(71) Applicant: Fujitsu Limited, Kawasaki-shi, Kanagawa 211-8588 (JP)
(72) Inventor: MOMOSE, Satoru, Kawasaki-shi Kanagawa 211-8588 (JP); YOSHIKAWA, Kota, Kawasaki-shi Kanagawa 211-8588 (JP); DOI, Shuuichi, Kawasaki-shi Kanagawa 211-8588 (JP)
(74) Representative: Fenlon, Christine Lesley
(86) International application number: PCT/JP2012/076930
(87) International publication number: WO 2014/061128

(57) **Abstract**

A photoelectric conversion device includes a positive electrode (2), a negative electrode (6), and a photoelectric conversion layer (4) including a p-type organic semiconductor material (4A) and an n-type organic semiconductor material (4B) that configure a bulk heterojunction. The photoelectric conversion layer (4) includes an amorphous polymer compound including a carbazole ring, a fluorene ring or a cyclopentadithiopene ring in a main chain as the p-type organic semiconductor material, and includes an amorphous fullerene derivative as the n-type organic semiconductor material. The photoelectric conversion layer has a diffraction peak corresponding to a plane spacing d = 1.6 nm to 2. 0 nm in an X-ray diffraction profile.

## Description

### TECHNICAL FIELD

The present invention relates to a photoelectric conversion device and a fabrication method therefor.

### BACKGROUND ART

In an organic thin film type solar cell, a photoelectric conversion layer configured from a combination of a p-type organic semiconductor polymer and an n-type organic semiconductor whose example is fullerene is used such that charge separation is performed when an exciton generated by incident light reaches a boundary between the p-type organic semiconductor polymer and the n-type organic semiconductor.

In such an organic thin film type solar cell as just described, a bulk heterojunction (BHJ) type photoelectric conversion layer is frequently used. This is referred to as bulk heterojunction type organic thin film type solar cell.

A bulk heterojunction type photoelectric conversion layer is formed by applying mixed solution, which consists of a p-type organic semiconductor polymer, an n-type organic semiconductor and suitable solvent, and drying the mixed solution. Then, during the course of drying the mixed solution, the p-type organic semiconductor material and the n-type organic semiconductor material individually aggregate spontaneously to cause phase separation, and as a result, a pn junction having a great specific surface area is formed.

It is to be noted that a technology is available wherein a p-type organic semiconductor material and an n-type organic semiconductor material have a double-layered structure or a p-type organic semiconductor material and an n-type organic semiconductor material are structured so as to have a complicated interface therebetween in order to enhance the fill factor to enhance the photoelectric conversion efficiency.

Further, research is being carried out to seek an ideal structure using a numerical simulation in order to enhance the short-circuit current density to enhance the photoelectric conversion efficiency. As an example, also a structure that exhibits superiority is available wherein pillars of a p-type organic semiconductor material and pillars of an n-type organic semiconductor material individually having a width on the order of nanometers are formed perpendicularly to a film plane of a photoelectric conversion film and juxtaposed alternately so as to form a checkered pattern in an in-plane direction.

Further, a technology is available wherein a crystalline organic semiconductor material whose transportability of carriers in the inside thereof enhances by crystallization is used for at least one of a p-type organic semiconductor material and an n-type organic semiconductor material in order to enhance the transportability of carriers to enhance the photoelectric conversion efficiency.

### CITATION LIST

### PATENT LITERTURE

PTL 1: U.S. Patent No. 5331183
PTL 2: Japanese Laid-Open Patent Publication No. 2002-76391
PTL 3: Japanese Laid-Open Patent Publication No. 2012-15434
PTL 4: Japanese Laid-Open Patent Publication No. 2012-33904

### NON-PATENT LITERTURE

NPL 1: Yutaka Matsuo et al., "Columnar Structure in Bulk Heterojunction in Solution-Processable Three-Layered p-i-n Organic Photovoltaic Devices Using Tetrabenzoporphyrin Precursor and Silylmethy [60] fullerene", J. AM. CHEM. SOC. 2009. 121, 16048-16050
NPL 2: Peter K. Watkins et al., "Dynamical Monte Carlo Modelling of Organic Solar Cells: The Dependence of Internal Quantum Efficiency on Morphology", Nano Letters, Vol. 5, NO. 9, pp. 1814-1818, 2005
NPL 3: Ta-Ya Chu et al., "Highly efficient polycarbazole-based organic photovoltaic devices", APPLIED PHYSICS LETTERS 95, 063304 (2009)

### SUMMARY OF INVENTION

### TECHNICAL PROBLEM

Incidentally, in an organic thin film type solar cell, a high photoelectric conversion efficiency is obtained in a low-illuminance indoor light environment. Therefore, organic thin film type solar cells can coexist well together with Si solar cells, which form a mainstream of solar cells at present, and have high future prospects.

However, in order to obtain a high photoelectric conversion efficiency in a low-illuminance indoor light environment, it is preferable to raise the light absorption efficiency using a photoelectric conversion layer having a great thickness. On the other hand, if only the film thickness of the photoelectric conversion layer is increased simply, the photoelectric conversion efficiency drops by a drop of the fill factor (FF) especially in a high-illuminance solar light environment. Therefore, it is difficult to obtain a high photoelectric conversion efficiency in both of a low-illuminance indoor light environment (low-illuminance condition) and a high-illuminance solar light environment (high-illuminance condition).

Therefore, it is demanded to obtain a high photoelectric conversion efficiency in both of a low-illuminance indoor light environment (low-illuminance condition) and a high-illuminance solar light environment (high-illuminance condition).

### SOLUTION TO PROBLEM

A photoelectric conversion device includes a positive electrode, a negative electrode, and a photoelectric conversion layer including a p-type organic semiconductor material and an n-type organic semiconductor material that configure a bulk heterojunction, including an amorphous polymer compound including a carbazole ring, a fluorene ring or a cyclopentadithiopene ring in a main chain as the p-type organic semiconductor material, and including an amorphous fullerene derivative as the n-type organic semiconductor material, wherein the photoelectric conversion layer has a diffraction peak corresponding to a plane spacing d = 1. 6 nm to 2.0 nm in an X-ray diffraction profile.

A fabrication method for a photoelectric conversion device includes applying and drying mixed liquid including an amorphous polymer compound including a carbazole ring, a fluorene ring or a cyclopentadithiopene ring in a main chain as a p-type organic semiconductor material and an amorphous fullerene derivative as an n-type organic semiconductor material, the p-type organic semiconductor material and the n-type organic semiconductor material configuring a bulk heterojunction, exposing the dried substance into an atmosphere including vapor of a solvent that preferentially dissolves the n-type organic semiconductor material rather than the p-type organic semiconductor material, and forming a photoelectric conversion layer having a diffraction peak corresponding to a plane spacing d = 1.6 nm to 2.0 nm in an X-ray diffraction profile.

### ADVANTAGEOUS EFFECTS OF INVENTION

Accordingly, with the present photoelectric conversion device and the fabrication method therefore, there is an advantage that a high photoelectric conversion efficiency in both of a low-illuminance indoor light environment (low-illuminance condition) and a high-illuminance solar light environment (high-illuminance condition).

### BRIEF DESCRIPTION OF DRAWINGS

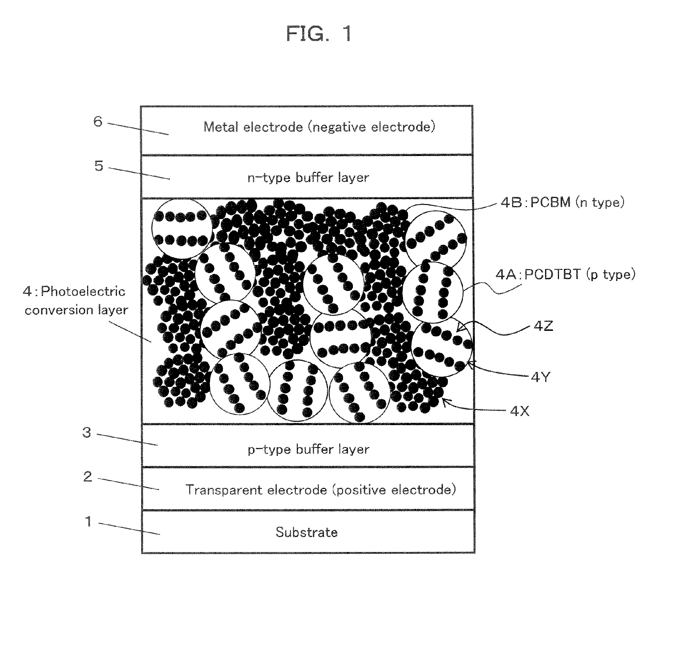

[FIG. 1] FIG. 1 is a schematic view depicting a configuration of a photoelectric conversion device according to a present embodiment.

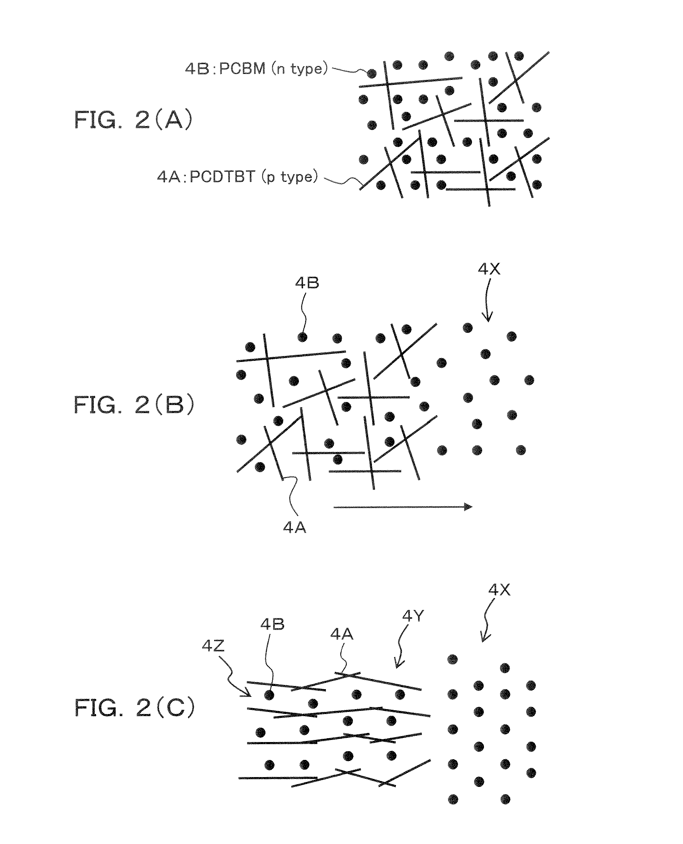

[FIG. 2] FIGS. 2(A) to 2(C) are views depicting a structure variation by vapor process in a fabrication method for the photoelectric conversion device according to the present embodiment, wherein FIG. 2(A) depicts a state before the vapor process is performed, FIG. 2(B) depicts a course in which the structure during the vapor process is varying and FIG. 2(C) depicts a state after the vapor process.

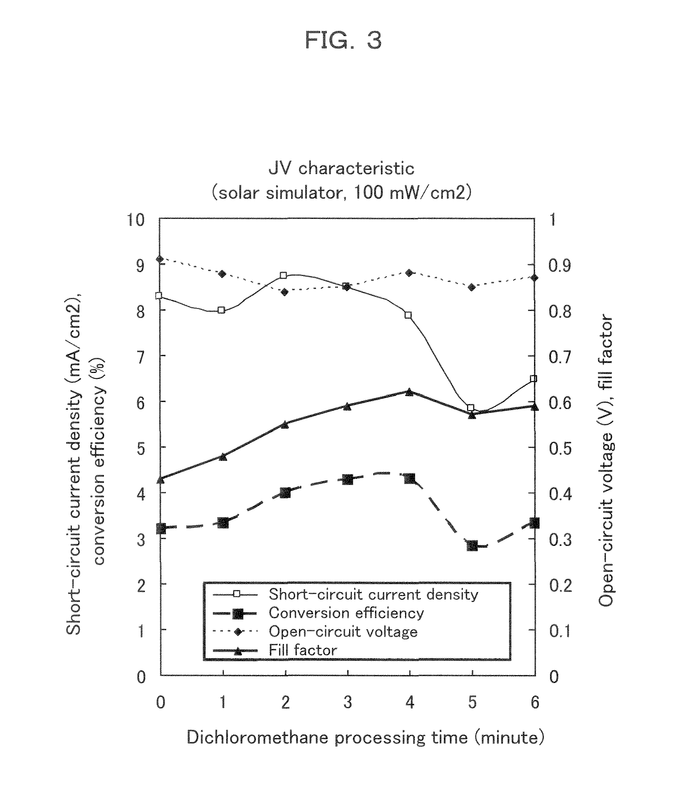

[FIG. 3] FIG. 3 is a view depicting a variation of a photoelectric conversion characteristic with respect to dichloromethane processing time of samples of an example 1 in a solar simulator having a radiation illuminance of 100 mW/cm².

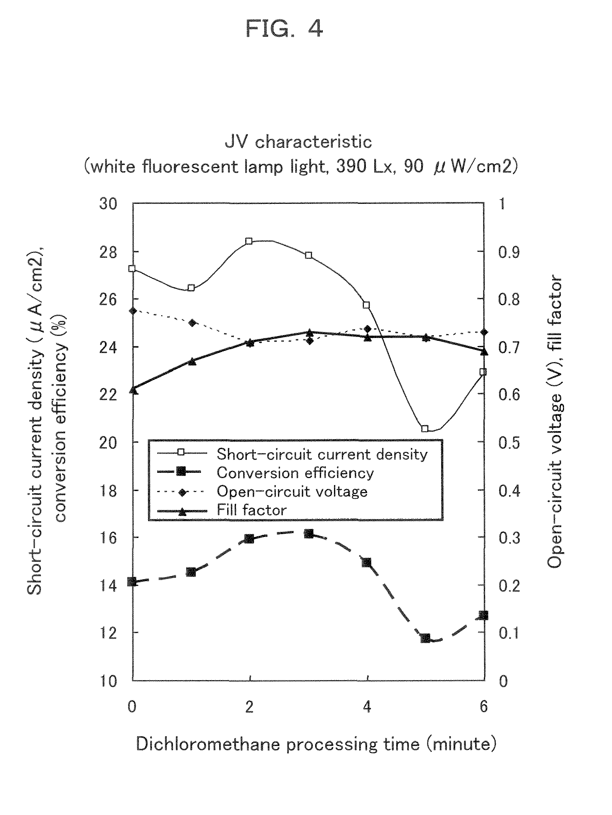

[FIG. 4] FIG. 4 is a view depicting a variation of a photoelectric conversion characteristic with respect to dichloromethane processing time of samples of the example 1 under white fluorescent lamp light of an illuminance of 390 Lx and a radiation illuminance of 90 µW/cm².

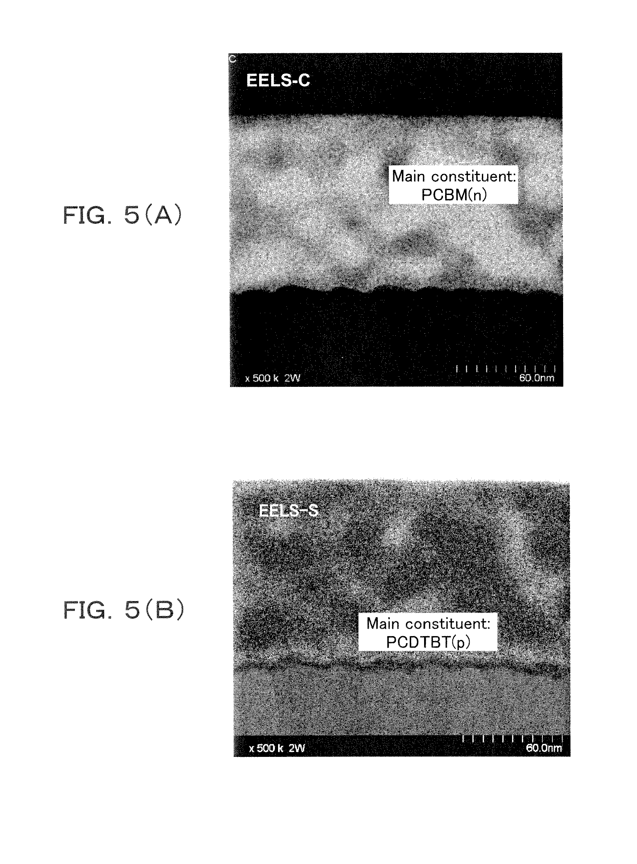

[FIG. 5] FIGS. 5 (A) and 5 (B) are views depicting a mapping image as a result when element mapping by electron energy loss spectroscopy is performed for a cross section of a sample of the example 1 (for which a dichloromethane process has been performed for four minutes), and wherein FIG. 5(A) depicts a mapping image (EELS-C) by the electron energy loss spectroscopy taking a carbon atom as a target and FIG. 5 (B) depicts a mapping image (EELS-S) by the electron energy loss spectroscopy taking a sulfur atom as a target.

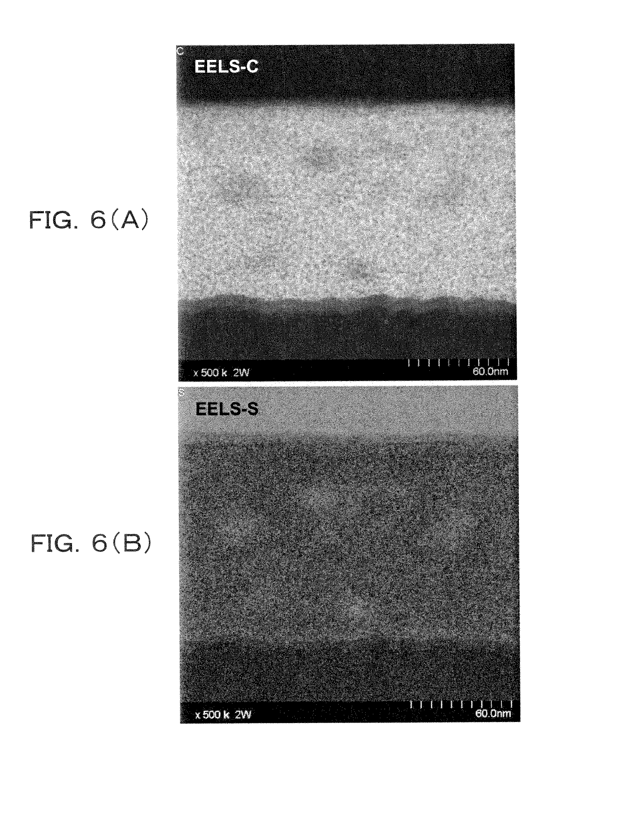

[FIG. 6] FIG. 6 (A) and 6(B) are views depicting a mapping image as a result when element mapping by electron energy loss spectroscopy is performed for a cross section of a sample of an example 2 (for which a dichloromethane process is not performed), and wherein FIG. 6(A) depicts a mapping image (EELS-C) by the electron energy loss spectroscopy using a carbon atom as a target and FIG. 6 (B) depicts a mapping image (EELS-S) by the electron energy loss spectroscopy taking a sulfur atom as a target.

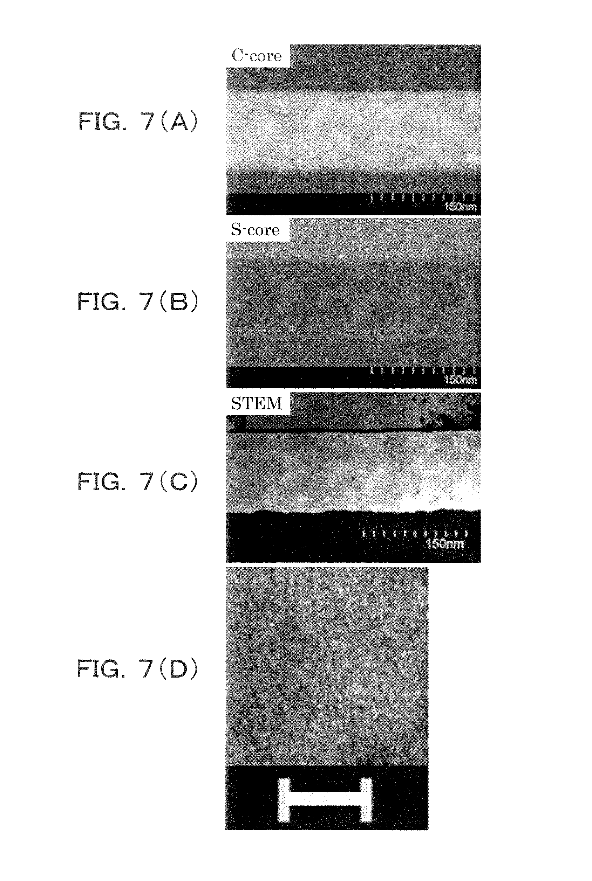

[FIG. 7] FIGS. 7(A), 7(B) and 7(C) are views depicting a mapping image (EELS-S) by the electron energy loss spectroscopy taking a carbon atom as a target, a mapping image (EELS-S) by the electron energy loss spectroscopy taking a sulfur atom as a target and a cross sectional image (STEM image) by a scanning transmission electron microscope, at a same location of a cross section of a sample of the example 1 (for which a dichloromethane process is performed for four minutes), and FIG. 7 (D) is a view depicting an enlarged image of a region in which a PCDTBT is a main constituent in FIG. 7(C).

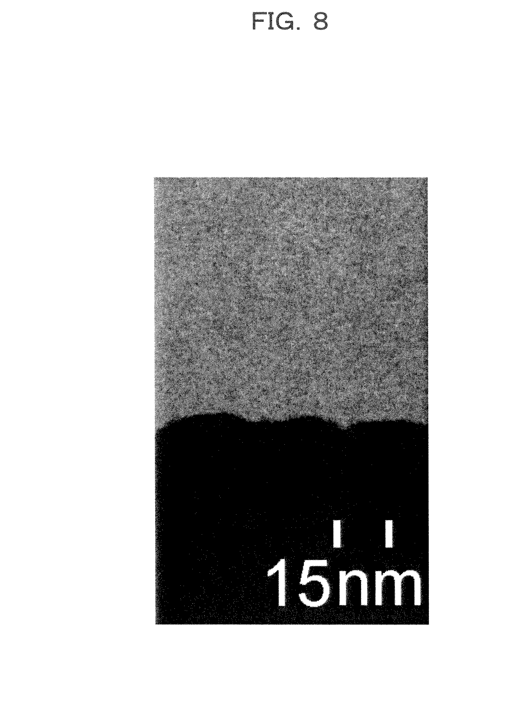

[FIG. 8] FIG. 8 is a view depicting a cross sectional image, by a scanning transmission electron microscope, of a cross section of a sample of the example 2 (for which a dichloromethane process is not performed).

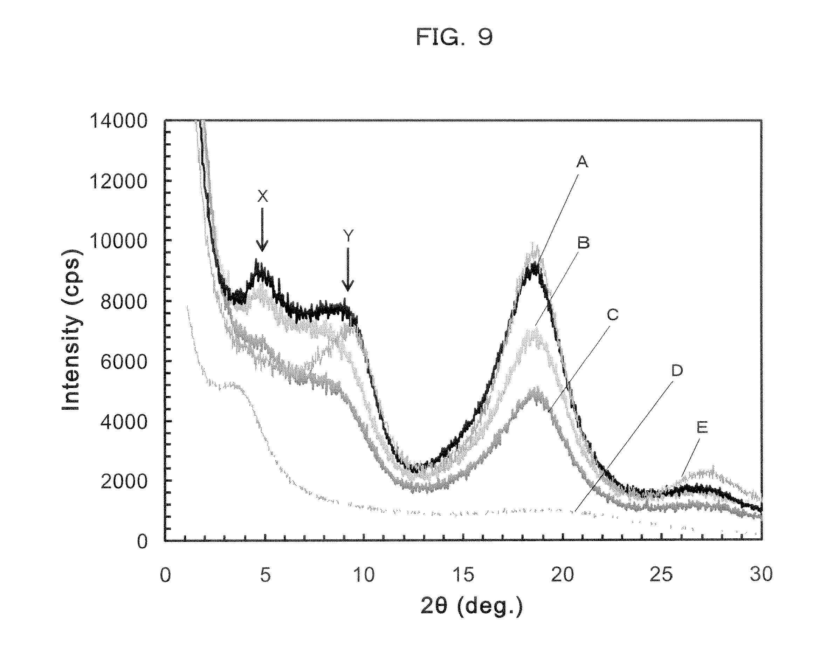

[FIG. 9] FIG. 9 is a view depicting an X-ray diffraction profile of a photoelectric conversion layer of a sample of the example 1 (for which a drying process is performed at approximately 25°C and a dichloromethane process is performed for two minutes), a sample of the example 2 (for which a drying process is performed at approximately 25°C but a dichloromethane process is not performed) and a comparative example 1 (for which a drying process is performed at approximately 60 °C but a dichloromethane process is not performed).

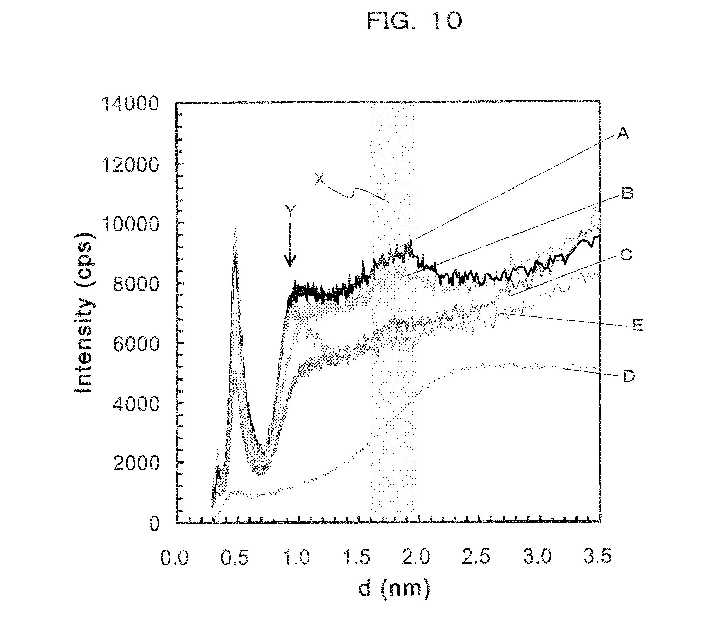

[FIG. 10] FIG. 10 is a view depicting an X-ray diffraction profile (wherein the axis of abscissa is a plane spacing d between diffraction planes) of a photoelectric conversion layer of a sample of the example 1 (for which a drying process is performed at approximately 25°C and a dichloromethane process is performed for two minutes), a sample of the example 2 (for which a drying process is performed at approximately 25 °C but a dichloromethane process is not performed) and a comparative example 1 (for which a drying process is performed at approximately 60°C but a dichloromethane process is not performed).

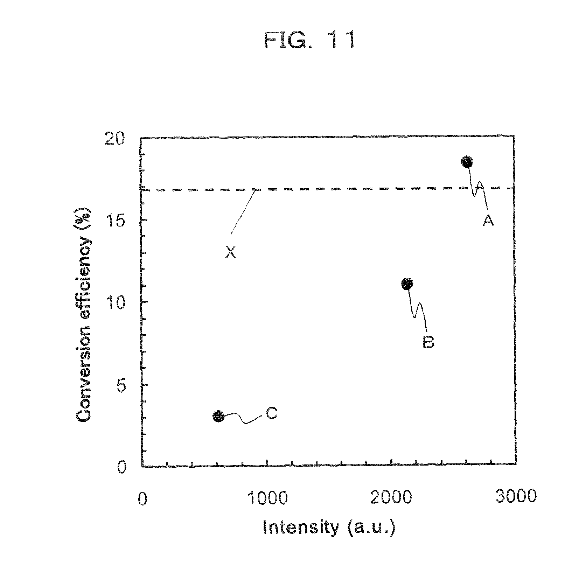

[FIG. 11] FIG. 11 is a view in which the integrated intensity at a portion, which corresponds to a plane spacing d = approximately 1.6 to approximately 2.0 nm, of the X-ray diffraction profile of a photoelectric conversion layer of a sample of the example 1 (for which a drying process is performed at approximately 25 °C and a dichloromethane process is performed for two minutes), a sample of the example 2 (for which a drying process is performed at approximately 25°C but a dichloromethane process is not performed) and a comparative example 1 (for which a drying process is performed at approximately 60°C but a dichloromethane process is not performed) is plotted in a relationship with a photoelectric conversion efficiency under white fluorescent lamp light (illuminance 390 Lx, radiation illuminance 90 µW/cm²).

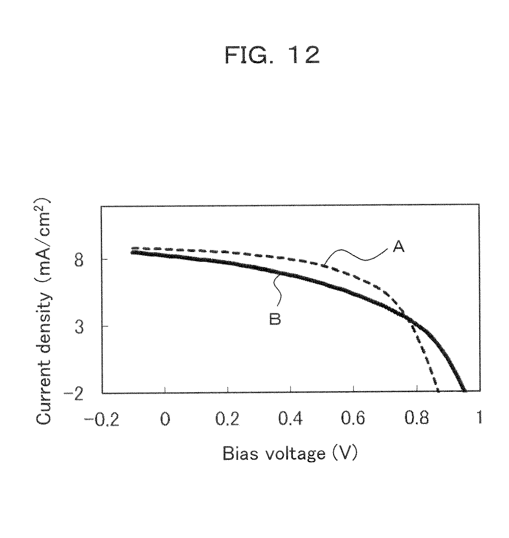

[FIG. 12] FIG. 12 is a view depicting an I-V curve in a solar simulator of a radiation illuminance of 100 mW/cm² of a sample of the example 1 (for which a dichloromethane process is performed for two minutes; filmthickness: approximately 80 nm) andasample of the example 2 (for which dichloromethane process is not performed; film thickness: approximately 80 nm).

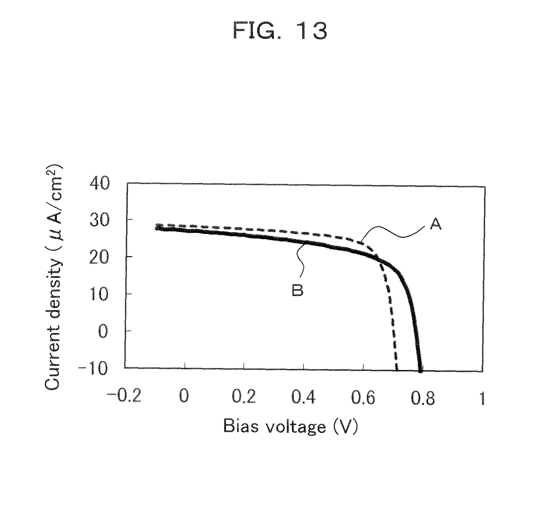

[FIG. 13] FIG. 13 is a view depicting an I-V curve under white fluorescent lamp light (illuminance 390 Lx, radiation illuminance 90 µW/cm²) of a sample of the example 1 (for which a dichloromethane process is performed for two minutes; film thickness: approximately 80 nm) and a sample of the example 2 (for which dichloromethane process is not performed; film thickness: approximately 80 nm).

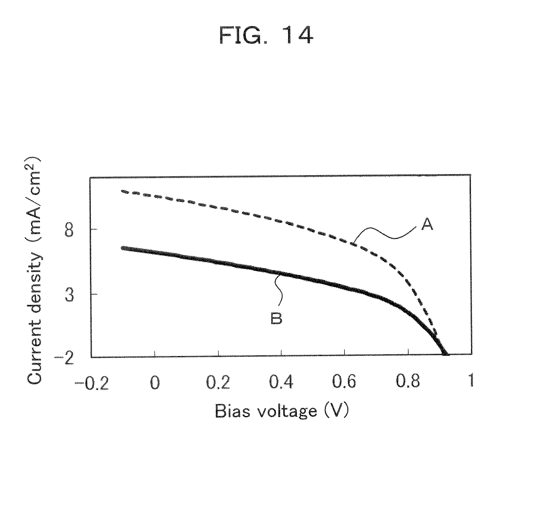

[FIG. 14] FIG. 14 is a view depicting an I-V curve in a solar simulator of a radiation illuminance of 100 mW/cm² of a sample of an example 3 (for which a dichloromethane process is performed for two minutes; film thickness: approximately 170 nm) and a sample of an example 4 (for which dichloromethane process is not performed; film thickness: approximately 170 nm).

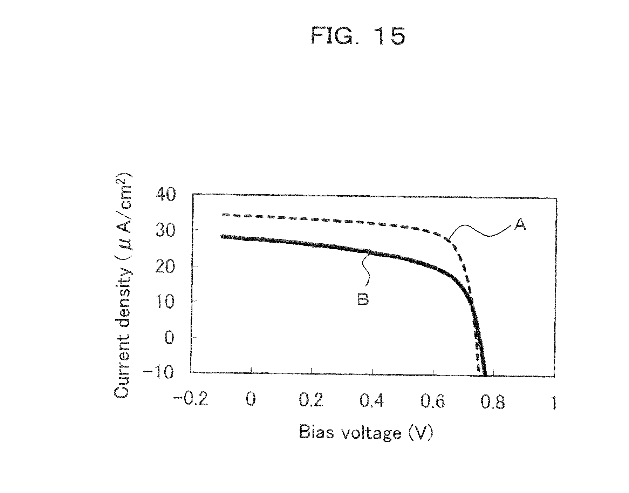

[FIG. 15] FIG. 15 is a view depicting an I-V curve under white fluorescent lamp light (illuminance 390 Lx, radiation illuminance 90 µW/cm²) of a sample of the example 3 (for which a dichloromethane process is performed for two minutes; film thickness: approximately 170 nm) and a sample of the example 4 (for which dichloromethane process is not performed; film thickness: approximately 170 nm).

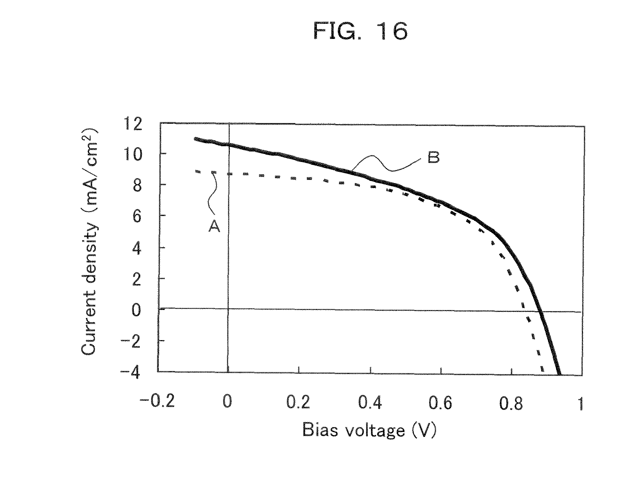

[FIG. 16] FIG. 16 is a view depicting an I-V curve in a solar simulator of a radiation illuminance of 100 mW/cm² of a sample of the example 1 (for which a dichloromethane process is performed for two minutes; filmthickness: approximately 80 nm) andasample of the example 3 (for which dichloromethane process is performed for two minutes; film thickness: approximately 170 nm).

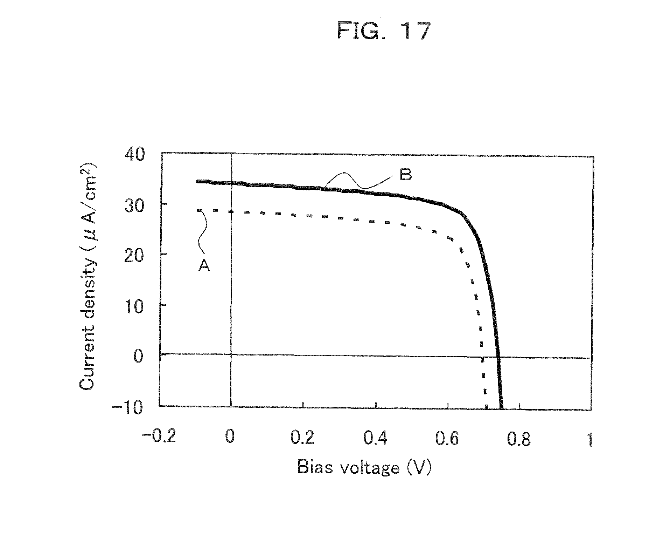

[FIG. 17] FIG. 17 is a view depicting an I-V curve under white fluorescent lamp light (illuminance 390 Lx, radiation illuminance 90 µW/cm²) of a sample of the example 1 (for which a dichloromethane process is performed for two minutes; film thickness: approximately 80 nm) and a sample of the example 3 (for which dichloromethane process is performed for two minutes; film thickness: approximately 170 nm).

### DESCRIPTION OF EMBODIMENTS

In the following, a photoelectric conversion device and a fabrication method therefor according to an embodiment of the present invention are described with reference to FIGS. 1 to 17.

The photoelectric conversion device according to the present embodiment is used, for example, as an organic thin film solar cell, particularly, a bulk heterojunction type organic thin film solar cell. Since such a bulk heterojunction type organic thin film solar cell as just described can be fabricated in a printing process, the fabrication cost can be decreased significantly in principle in comparison with a solar cell that forms a mainstream of solar cells at present and in which an inorganic semiconductor is used by stacking in a vacuum process.

As depicted in FIG. 1, the present photoelectric conversion device includes a substrate 1, a positive electrode 2 as a lower electrode, a positive electrode side buffer layer 3, a photoelectric conversion layer 4, a negative electrode side buffer layer 5 and a negative electrode 6 as an upper electrode. It is to be noted that the photoelectric conversion layer 4 is referred to also as photoelectric conversion film.

Here, the substrate 1 is a transparent substrate that transmits incident light therethrough and is, for example, a glass substrate.

The positive electrode 2 is a transparent electrode that is provided on the substrate 1 and transmits incident light therethrough, and is, for example, an ITO (Indium Tin Oxide) electrode.

The positive electrode side buffer layer 3 is provided on the positive electrode 2, namely, between the positive electrode 2 and the photoelectric conversion layer 4, and functions as a hole transportation layer. It is to be noted that the positive electrode side buffer layer 3 is referred to also as p-type buffer layer. The positive electrode side buffer layer 3 may be configured so as to include a material in which the energy of the lowest unoccupied molecular orbital (LUMO) is shallower than that of the n-type organic semiconductor material that configures the bulk heterojunction of the photoelectric conversion layer 4 (namely, is near to the vacuum level) and energy of the highest occupied molecular orbital (HOMO) is shallower than that of the p-type organic semiconductor material that configures the bulk heterojunction of the photoelectric conversion layer 4. Here, the positive electrode side buffer layer 3 is a layer including, for example, MoO₃, namely, a layer including molybdenum oxide (VI). It is to be noted that the positive electrode side buffer layer 3 may not be provided. However, where the positive electrode side buffer layer 3 is provided, a more superior characteristic such as, for example, enhancement of the short-circuit current density is obtained.

The photoelectric conversion layer 4 is provided on the positive electrode side buffer layer 3. In particular, the photoelectric conversion layer 4 is provided between the positive electrode side buffer layer 3 and the negative electrode side buffer layer 5.

The negative electrode side buffer layer 5 is provided on the photoelectric conversion layer 4, namely, between the photoelectric conversion layer 4 and the negative electrode 6, and functions as an electron transport layer. It is to be noted that the negative electrode side buffer layer 5 is referred to also as n-type buffer layer. The negative electrode side buffer layer 5 may be configured so as to include a material in which the energy of the highest occupied molecular orbital is deeper than that of the p-type organic semiconductor material that configures the bulk heterojunction of the photoelectric conversion layer 4 (namely, is far from the vacuum level) and energy of the lowest occupied molecular orbital is deeper than that of the n-type organic semiconductormaterial that configures the bulk heterojunction of the photoelectric conversion layer 4. Here, the negative electrode side buffer layer 5 is a layer including, for example, TiOₓ. It is to be noted that the negative electrode side buffer layer 5 may not be provided. However, where the negative electrode side buffer layer 5 is provided, a more superior characteristic such as, for example, enhancement of the short-circuit current density is obtained.

It is to be noted that a hole block layer may be provided in place of the negative electrode side buffer layer 5. In particular, a hole block layer may be provided between the photoelectric conversion layer 4 and the negative electrode 6. For example, the hole block layer may be configured from a layer including lithium fluoride. It is to be noted that the hole block layer is referred to also as insulating hole block layer. While the hole block layer may not be provided, by providing the hole block layer, a more superior characteristic such as, for example, enhancement of the short-circuit current density or the fill factor (FF) is obtained.

The negative electrode 6 is a metal electrode provided on the negative electrode side buffer layer 5 and is, for example, an aluminum electrode.

In the present embodiment, the photoelectric conversion layer 4 is a bulk heterojunction type photoelectric conversion layer that includes a p-type organic semiconductor material 4A and an n-type organic semiconductor material 4B that configure a bulk heterojunction, includes an amorphous (non-crystalline) polymer compound including a carbazole ring, a fluorene ring or a cyclopentadithiopene ring in a main chain as the p-type organic semiconductor material 4A, and includes an amorphous (non-crystalline) fullerene derivative as the n-type organic semiconductor material 4B.

Especially, it is preferable to configure the photoelectric conversion layer 4 so as to include, as the amorphous p-type organic semiconductor material 4A in a non-crystalized state (amorphous state), poly-[N-9'-heptadecanyl-2,7-carbazole-alt-5,5-(4',7'-di-2-t hienyl-2',1',3'-benzothiadiazole) (hereinafter referred to as PCDTBT) represented by the chemical formula (1) given below and include, as the amorphous n-type organic semiconductor material 4A in a non-crystalized state (amorphous state), any one or a mixture (which are hereinafter referred to as PCBM) of [6, 6] -phenyl-C₇₁ butyric acid methyl ester (PC71BM produced from C70) represented by the chemical formula (2) given below, [6,6]-phenyl-C₆₁ butyric acid methyl ester (PC61BM produced from C60) represented by the chemical formula (3) given below and [6,6]-Phenyl-C₈₅ butyric acid methyl ester (PC85BM produced from C84) represented by the chemical formula (4) given below. In this case, the photoelectric conversion layer 4 is configured from a mixture of an amorphous PCDTBT and an amorphous PCBM. Here, the reason why a PCDTBT is included as the p-type organic semiconductor material 4A is that the energy level of the highest occupied molecular orbital is comparatively low and a high open voltage is easily obtained. Further, the reason why a PCBM is included as the n-type organic semiconductor material 4B is that it is soluble in various organic solvents.

[Chemical Formula 1]

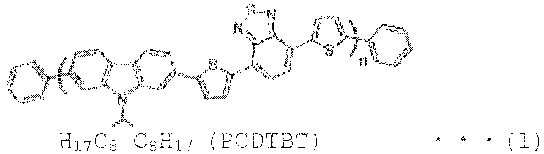

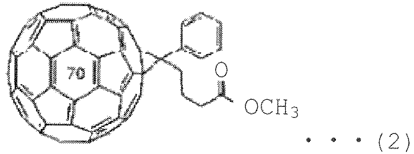

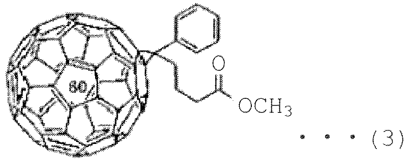

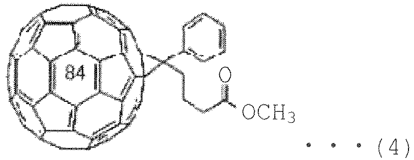

It is to be noted that the photoelectric conversion layer 4 may include, as the amorphous p-type organic semiconductor material 4A in a non-crystalized state, an amorphous polymer compound including a carbazole ring, a fluorene ring or a cyclopentadithiopene ring in a main chain. Since an amorphous polymer compound including a carbazole ring, a fluorene ring or a cyclopentadithiopene ring is a main chain is likely to twist at portions in the front and rear of the rings and the main chain twists spontaneously, the amorphous polymer compound is low in planarity and less likely to form a lamella structure and therefore is liable to cause degradation in crystallinity and is not very high in crystallinity. Such an amorphous polymer compound that is low in trend to spontaneously form crystal as just described may be used for the p-type organic semiconductor material 4A. The reason why such a material having low crystallinity as described above is used is that it is difficult for a material having high crystallinity to cooperate with such an n-type organic semiconductor material 4B as hereinafter described to form a fine stacked structure on the order of nanometers. On the other hand, different from a crystalline p-type organic semiconductor material that forms crystal, an amorphous polymer compound including a carbazole ring, a fluorene ring or a cyclopentadithiopene ring in a main chain has a conductivity also in a main chain direction. Therefore, even if the crystallinity is low, the transportation of carriers is maintained, and consequently, the amorphous polymer compound can be used as the p-type organic semiconductor material 4A of the photoelectric conversion layer 4.

In particular, the photoelectric conversion layer 4 may include, as the amorphous p-type organic semiconductor material 4A in a non-crystalized state, any one material selected from the group consisting of poly-[N-9'-heptadecanyl-2,7-carbazole-alt-5,5-(4',7'-di-2-t hienyl-2',1',3'-benzothiadiazole)], poly[(9,9-dioctylfluorenyl-2,7-diyl)-alt-co-(1,4-benzo-{2,1 ',3}-thiadiazole)] represented by the chemical formula (5) given below, poly[(9,9-dihexylfluoreny-2,7-diyl)-alt-co-(bithophene)] represented by the chemical formula (6) given below, poly[2,6-(4,4-bis-(2-ethylhexyl)-4H-cyclopenta[2,1-b;3,4-b' ]-dithiophene)-alt-4,7-(2,1,3-benzothiadiazole)] represented by the chemical formula (7) given below, poly[2,7-(9-(2'-ethykhexyl)-9-hexyl-fluorene)-alt-5,5-(4'-7 '-di-2-thienyl-2',1',3'-benzothiadiazole] represented by the chemical formula (8) given below, and poly[2,7-(9,9)-dioctylfluorene]-alt-5,5-(4',7'-di-2-thienyl -2',1',3'-benzothiadiazole) represented by the chemical formula (9) given below. It is to be noted that the p-type organic semiconductor material 4A is hereinafter referred to also as p-type polymer compound or p-type polymer material.

[Chemical Formula 2]

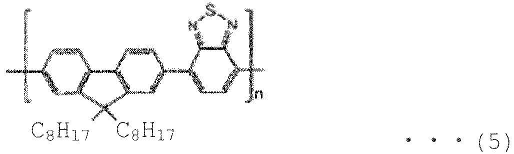

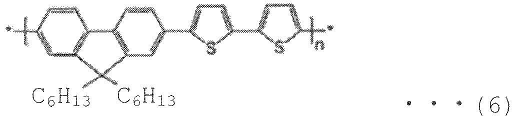

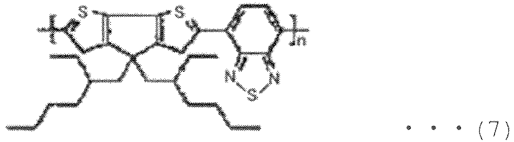

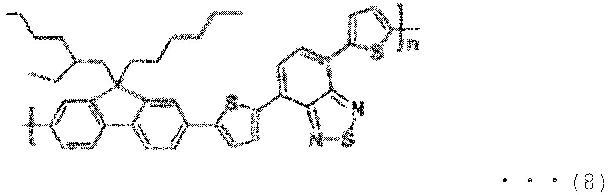

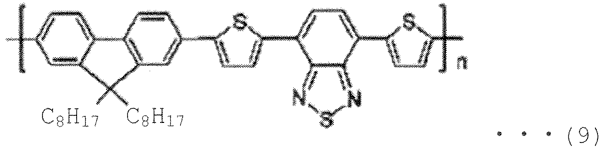

Further, the photoelectric conversion layer 4 may be configured so as to include, as the amorphous n-type organic semiconductor material 4B in a non-crystalized state, an amorphous fullerene derivative soluble in an organic solvent and compatible with the p-type organic semiconductor material 4A. It is to be noted that, although the fullerene derivative can be crystalized in a single substance by performing heat treatment at a high temperature (for example, such a temperature as exceeds 100°C), it does not crystalize and remains amorphous when it coexists with the p-type organic semiconductor material 4A and besides heat treatment at a high temperature is not performed when to form the photoelectric conversion layer 4 as in an example hereinafter described.

In particular, the photoelectric conversion layer 4 may include, as the amorphous n-type organic semiconductor material 4B in a non-crystalized state, any one material selected from the group consisting of [6,6]-phenyl-C₇₁ butyric acid methyl ester, [6,6]-phenyl-C₆₁ butyric acid methyl ester, [6,6]-Phenyl-C₈₅ butyric acid methyl ester, indene-C 60 bisadduct (ICBA) represented by the chemical formula (10) given below, [6,6] diphenyl C₆₂bis (butyric acid methyl ester) represented by the chemical formula (11) given below, [6,6] diphenyl C₇₂bis (butyric acid methyl ester), [6,6]-phenyl-C₆₁ butyric acid (3-ethylthiophene) ester presented by the chemical formula (12) given below, 1-(3-methoxycarbonyl)propyl-1-thienyl-6,6-methanofullerene (ThCBM) represented by the chemical formula (13) given below, and [6,6]-phenyl-C₆₁ butyric acid (2,5-dibromo-3-ethylthiophene) ester represented by the chemical formula (14) given below.

[Chemical Formula 3]

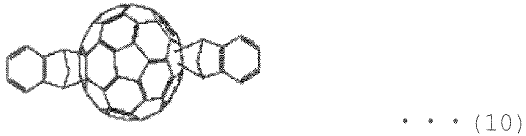

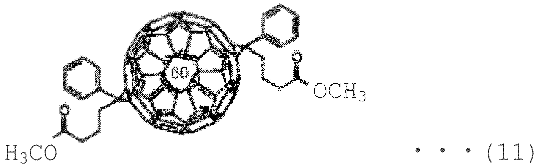

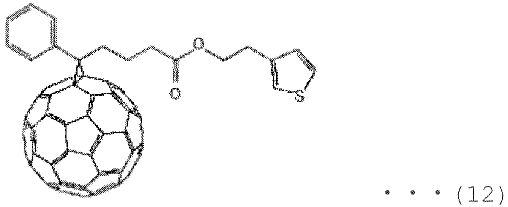

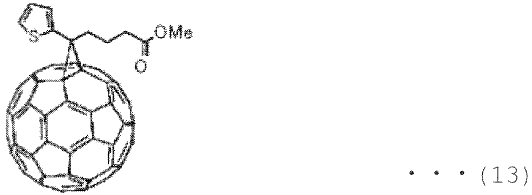

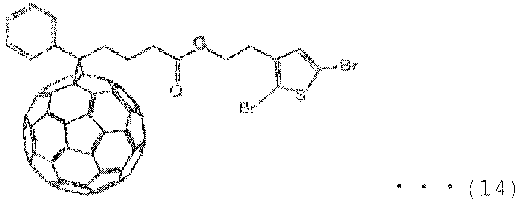

Further, in the present embodiment, the photoelectric conversion layer 4 has an n-type organic semiconductor region 4X in which the non-crystalized amorphous n-type organic semiconductor material 4B is a main constituent and a p-type organic semiconductor region 4Y in which the non-crystalized amorphous p-type organic semiconductor material 4A is a main constituent, and the p-type organic semiconductor region 4Y is formed so as to fill up a gap of the n-type organic semiconductor region 4X. It is to be noted that the n-type organic semiconductor region 4X in which the n-type organic semiconductor material 4B is a main constituent is referred to also as n-type organic semiconductor material domain. Further, the p-type organic semiconductor region 4Y in which the p-type organic semiconductor material 4A is a main constituent is referred to also as p-type organic semiconductor material domain. In the n-type organic semiconductor region 4X, the n-type organic semiconductor material 4B has a substantially spherical aggregate shape. Meanwhile, the p-type organic semiconductor region 4Y has a stacked structure 4Z in which the n-type organic semiconductor material 4B and the p-type organic semiconductor material 4A are stacked alternately. In the photoelectric conversion layer 4 having such a stacked structure 4Z as just described, the non-crystalized amorphous n-type organic semiconductor material 4B and the non-crystalized amorphous p-type organic semiconductor material 4A configure a bulk heterojunction. It is to be noted that such a stacked structure 4Z as described above is referred to also as periodically ordered structure or fine stacked structure.

In particular, the photoelectric conversion layer 4 in the present embodiment has, in the inside thereof, a fine structure in which phase separation between the p-type organic semiconductor material 4A and the n-type organic semiconductor material 4B has proceeded.

Especially, the photoelectric conversion layer 4 in the present embodiment has the stacked structure 4Z in which the layered n-type organic semiconductor material 4B penetrates in the inside of the photoelectric conversion layer 4, namely, the inside of the p-type organic semiconductor region 4Y. In particular, the photoelectric conversion layer 4 in the present embodiment has the stacked structure 4Z in which the layered n-type organic semiconductor material 4B is inserted in a matrix of the p-type organic semiconductor material 4A. In this case, since charge separation occurs also in the p-type organic semiconductor region 4Y, the charge separation efficiency enhances. Consequently, not only the short-circuit current density but also the photoelectric conversion efficiency enhances. Especially, the charge separation efficiency in a low-illuminance indoor light environment (low-illuminance condition) in which the density of excitons and charge generated in the inside of the photoelectric conversion layer 4 is low enhances. Consequently, not only the short-circuit current density but also the photoelectric conversion efficiency enhances.

Further, in the n-type organic semiconductor region 4X of the photoelectric conversion layer 4 in the present embodiment, molecules of the n-type organic semiconductor material 4B in the inside thereof are arranged in accordance with a high regularity, and a state in which electrons are more likely to move is established. Meanwhile, in the p-type organic semiconductor region 4Y, electrons can pass through the layered n-type organic semiconductor material 4B and reach the n-type organic semiconductor region 4X. Therefore, the transportability of electrons in the inside of the photoelectric conversion layer 4 enhances. On the other hand, while the p-type organic semiconductor region 4Y has the stacked structure 4Z, since the p-type organic semiconductor material 4A exists by an overwhelmingly large amount, portions of the p-type organic semiconductor material 4A contact sufficiently with each other. Therefore, in comparison with an alternative p-type organic semiconductor region that has a structure in which the p-type organic semiconductor material 4A and the n-type organic semiconductor material 4B are jumbled disorderly, namely, does not have the stacked structure 4Z, the movability of holes in the inside of the photoelectric conversion layer 4 differs little, and the transportability of holes is secured. In this manner, in comparison with a p-type organic semiconductor region that does not have the stacked structure 4Z, the routes along which electrons and holes move to the negative electrode 6 and the positive electrode 2 are simplified and the probability with which electrons and holes are recombined with each other can be decreased. Especially, recombination of carriers generated by a great amount in a high-illuminance solar light environment (high-illuminance condition) can be prevented. Therefore, also where the film thickness of the photoelectric conversion layer 4 is made comparatively great in order to obtain a high photoelectric conversion efficiency in a low-illuminance indoor light environment, the fill factor in a high-illuminance solar light environment can be improved. Consequently, the photoelectric conversion efficiency can be enhanced. As a result, a high photoelectric conversion efficiency can be obtained in both of a low-illuminance indoor light environment and a high-illuminance solar light environment.

In this manner, since the photoelectric conversion layer 4 of the present embodiment uses an amorphous material for both of the n-type organic semiconductor material 4B and the p-type organic semiconductor material 4A, in comparison with an alternative case in which a crystalline material is used and crystalized as described in an example hereinafter described, the photoelectric conversion layer 4 can be formed at a low temperature such as, for example, a room temperature. Therefore, growth of the domain structure in the organic semiconductor materials 4A and 4B is reduced and mixture of the n-type organic semiconductor material 4B and the p-type organic semiconductor material 4A along the interface between them on the level of molecules is promoted, and the stacked structure 4Z is formed by an interaction among molecules. Consequently, the transportability of the carriers enhances and the charge separation efficiency and the photoelectric conversion efficiency enhance.

Here, the stacked structure 4Z provided in the photoelectric conversion layer 4 described above does not have any of materials of the amorphous n-type organic semiconductor material 4B and the amorphous p-type organic semiconductor material 4A as simple substances.

Therefore, the photoelectric conversion layer 4 that has the stacked structure 4Z described above has a diffraction peak corresponding to a plane spacing d = 1.6 nm to 2.0 nm in an X-ray diffraction profile as described in detail in the description of an example given hereinbelow. In particular, a diffraction peak corresponding to a plane spacing d = 1.6 nm to 2.0 nm in an X-ray diffraction profile appears arising from the stacked structure 4Z that is provided in the p-type organic semiconductor region 4Y of the photoelectric conversion layer 4 and in which the n-type organic semiconductor material 4B and the p-type organic semiconductor material 4A are stacked alternately. Therefore, the diffraction peak corresponding to the plane spacing d = 1.6 nm to 2.0 nm in an X-ray diffraction profile is a diffraction peak arising from the stacked structure 4Z in which the n-type organic semiconductor material 4B and the p-type organic semiconductor material 4A are stacked alternately.

Further, the photoelectric conversion layer 4 having the n-type organic semiconductor region 4X in which molecules of the n-type organic semiconductor material 4B described above are arranged with a high regularity has, in the X-ray diffraction profile, a diffraction peak between a diffraction peak corresponding to a (111) plane and a different diffraction peak corresponding to a (11-1) plane in an X-ray diffraction profile of a simple substance of the n-type organic semiconductor material 4Bas described in detail in the description of an example given hereinbelow.

Incidentally, the photoelectric conversion layer 4 having such a configuration as described above can be obtained in the following manner.

In particular, mixed liquid (mixed solution) is applied and dried first which includes an amorphous polymer compound including a carbazole ring, a fluorene ring or a cyclopentadithiopene ring in a main as the p-type organic semiconductor material 4A and an amorphous fullerene derivative as the n-type organic semiconductor material 4B, the p-type organic semiconductor material 4A and the n-type organic semiconductor material 4B configuring a bulk heterojunction.

Then, the intermediate product is exposed in an atmosphere including vapor of a solvent (here, an organic solvent) that preferentially dissolves the n-type organic semiconductor material 4B rather than the p-type organic semiconductor material 4A. In particular, vapor process (organic solvent vapor process) for causing vapor of a solvent that preferentially dissolves the n-type organic semiconductor material 4B rather than the p-type organic semiconductor material 4A to act on the intermediate product is performed for the intermediate product. Here, as the solvent for the vapor process (here, an organic solvent), a solvent may be used which is high in solubility of the n-type organic semiconductor material 4B and is low in solubility of the p-type organic semiconductor material 4A in comparison with the solubility of the n-type organic semiconductor material 4B. For example, dichloromethane or chloroform may be used, and especially, it is preferable to use dichloromethane.

The photoelectric conversion layer 4 having such a stacked structure 4Z as described above, namely, the photoelectric conversion layer 4 having a diffraction peak corresponding to a plane spacing d = 1.6 nm to 2.0 nm in an X-ray diffraction profile, is obtained in this manner. Further, the photoelectric conversion layer 4 having the n-type organic semiconductor region 4X in which molecules of the n-type organic semiconductor material 4B described above are arranged with a high regularity, namely, the photoelectric conversion layer 4 having, in an X-ray diffraction profile, a diffraction peak between a diffraction peak corresponding to a (111) plane and another diffraction peak corresponding to a (11-1) plane in an X-ray diffraction profile of a simple substance of the n-type organic semiconductor material 4B, is obtained.

A process capable of obtaining the photoelectric conversion layer 4 having such a configuration as described above by performing the vapor process described above is further described.

First, before the vapor process described above is performed, a mixture solid of the n-type organic semiconductor material 4B and the p-type organic semiconductor material 4A (namely, a photoelectric conversion layer for which the vapor process described above is not performed) has a bulk heterojunction structure having a low structure regularity as depicted in FIG. 2(A).

On the other hand, by performing the vapor process described above, molecules of a solvent (here, an organic solvent) that preferentially dissolves the n-type organic semiconductor material 4B rather than the p-type organic semiconductor material 4A penetrate the mixture solid of the n-type organic semiconductor material 4B and the p-type organic semiconductor material 4A. As a result, movement of the molecules of the n-type organic semiconductor material 4 B becomes easy. Consequently, the photoelectric conversion layer 4 having such a configuration as described above, namely, the photoelectric conversion layer 4 having the stacked structure 4Z described above and having the n-type organic semiconductor region 4X in which molecules of the n-type organic semiconductor material 4B described above are arranged with a high regularity as depicted in FIG. 2(C), is obtained.

In particular, if molecules of a solvent (here, an organic solvent) that preferentially dissolves the n-type organic semiconductor material 4B rather than the p-type organic semiconductor material 4A penetrate the mixture solid of the n-type organic semiconductor material 4B and the p-type organic semiconductor material 4A, then the n-type organic semiconductor material 4B is dissolved and discharged from a matrix formed by the p-type organic semiconductor material 4A. As a result, the n-type organic semiconductor material 4B aggregates itself in order to minimize the surface energy thereby to form the n-type organic semiconductor region 4X (n-type domain). Here, FIG. 2(B) depicts a course in which the structure varies.

While the formation of the phase separation structure progresses in such a manner as described above, not all of the n-type organic semiconductor material 4B fetched in the matrix of the p-type organic semiconductor material 4A aggregate to the n-type organic semiconductor region 4X but a small amount of the n-type organic semiconductor materials 4B remains in the matrix of the p-type organic semiconductor material 4A. Then, the small amount of the n-type organic semiconductor materials 4B remaining in the matrix of the p-type organic semiconductor material 4A moves so that the potential energy thereof is minimized until a regular arrangement is formed. At this time, since molecules of the solvent (here, organic solvent) that preferentially dissolves the n-type organic semiconductor material 4B rather than the p-type organic semiconductor material 4A are weak in dissolution action on the p-type organic semiconductor material 4A, the p-type organic semiconductor material 4A are not movable by a great distance. Therefore, growth of the arrangement structure of the n-type organic semiconductor material 4B is restricted so that it progresses in such a direction and with such a size that the movement amount of the p-type organic semiconductor material 4A may be minimum.

As a result, the photoelectric conversion layer 4 having such a configuration as described above, namely, the photoelectric conversion layer 4 having the stacked structure 4Z described above and besides having the n-type organic semiconductor region 4X in which molecules of the n-type organic semiconductor material 4B described above are arranged with a high regularity as depicted in FIG. 2 (C) is obtained. In other words, the photoelectric conversion layer 4 in which the structure regularity enhances in both of the n-type organic semiconductor region 4X and the p-type organic semiconductor region 4Y is obtained. It is to be noted that, while, also in the photoelectric conversion layer 4 obtained by applying mixed liquid including the n-type organic semiconductor material 4B and the p-type organic semiconductor material 4A and drying the resulting intermediate product, for example, at a temperature lower than 60°C (preferably, at a room temperature of approximately 25°C), the stacked structure 4Z in which the n-type organic semiconductor material 4B is inserted in the matrix of the p-type organic semiconductor material 4A is partially formed, by performing the vapor process described above, the stacked structure 4Z can be developed and formation of a regular arrangement structure progresses also in the n-type organic semiconductor region 4X.

Now, a fabrication method for the photoelectric conversion device according to the present embodiment is described in detail.

First, a positive electrode 2 (transparent electrode) is formed on a substrate 1 (transparent substrate).

Then, a positive electrode side buffer layer (here, a layer including MoO₃) 3 is formed on the positive electrode 2.

Then, a photoelectric conversion layer 4 is formed on the positive electrode side buffer layer 3.

In particular, mixed liquid that includes an amorphous polymer compound (here, PCDTBT) including a carbazole ring, a fluorene ring or a cyclopentadithiopene ring in a main chain as the p-type organic semiconductor material 4A and includes an amorphous fullerene derivative (here, PCBM) as the n-type organic semiconductor material 4B is applied (applying step), and the resulting intermediate product is dried at a temperature, for example, lower than approximately 60°C (preferably, at a room temperature of approximately 25°C) (drying step).

Then, the intermediate product (the dried substance) is exposed in an atmosphere including vapor of a solvent that preferentially dissolves the n-type organic semiconductor material 4B rather than the p-type organic semiconductor material 4A (here, dichloromethane as an organic solvent). The process just described is called vapor process, organic solvent vapor process or dichloromethane process.

As a result, a photoelectric conversion layer 4 having such a stacked structure 4Z as described above, namely, a photoelectric conversion layer 4 having a diffraction peak corresponding to a plane spacing d = 1.6 nm to 2.0 nm in an X-ray diffraction profile, is obtained. Further, the photoelectric conversion layer 4 having the n-type organic semiconductor region 4X in which molecules of the n-type organic semiconductor material 4B are arranged with a high regularity, namely, the photoelectric conversion layer 4 having, in an X-ray diffraction profile, a diffraction peak between a diffraction peak corresponding to a (111) plane and another diffraction peak corresponding to a (11-1) plane in an X-ray diffraction profile of a simple substance of the n-type organic semiconductor material 4B, is obtained.

It is to be noted here that, while the photoelectric conversion layer 4 having such a stacked structure 4Z as described above, namely, the photoelectric conversion layer 4 having a diffraction peak corresponding to a plane spacing d = 1.6 nm to 2.0 nm in the X-ray diffraction profile, is obtained by performing the vapor process after the intermediate product is dried at a temperature, for example, lower than approximately 60°C (preferably, at a room temperature of approximately 25°C), the method for obtaining the photoelectric conversion layer 4 is not limited to this. In particular, although the vapor process here is performed after the intermediate product is dried, for example, at a temperature lower than approximately 60°C (preferably, at room temperature of approximately 25°C) in order that such a stacked structure 4Z as described above is developed and a diffraction peak corresponding to a plane spacing d = 1.6 nm to 2.0 nm appears conspicuously in an X-ray diffraction profile, the method for obtaining the photoelectric conversion layer 4 is not limited to this. For example, even if the photoelectric conversion layer 4 is formed by drying the intermediate product at a temperature, for example, lower than approximately 60°C (preferably, at a room temperature of approximately 25°C) but without performing the vapor process, the photoelectric conversion layer 4 having such a stacked structure 4Z as described above, namely, the photoelectric conversion layer 4 having a diffraction peak corresponding to a plane spacing d = 1.6 nm to 2.0 nm in an X-ray diffraction profile, can be obtained. However, in order to develop such a stacked structure 4Z as described above so that a diffraction peak corresponding to a plane spacing d = 1.6 nm to 2.0 nm may appear conspicuously in an X-ray diffraction profile, it is preferable to further perform thevaporprocess. In contrast, if the photoelectric conversion layer is formed by drying the intermediate product at a temperature equal to or higher than approximately 60°C but without performing the vapor process, then it is difficult to obtain the photoelectric conversion layer 4 having such a stacked structure 4Z as described above, namely, the photoelectric conversion layer 4 having a diffraction peak corresponding to a plane spacing d = 1.6 nm to 2.0 nm in an X-ray diffraction profile. This is because, where the intermediate product is dried at a temperature equal to or higher than approximately 60°C, it is difficult to obtain the photoelectric conversion layer 4 having such a stacked structure 4Z as described above, namely, the photoelectric conversion layer 4 having a diffraction peak corresponding to a plane spacing d = 1.6 nm to 2.0 nm in an X-ray diffraction profile.

Then, a hole block layer (here, a layer including lithium fluoride) that functions also as the negative electrode side buffer layer 5 is formed on the photoelectric conversion layer 4.

Thereafter, a negative electrode 6 (metal electrode) is formed on the hole block layer 5.

Then, the intermediate product is encapsulated, for example, in a nitrogen atmosphere, and a photoelectric conversion device is completed thereby.

Accordingly, with the photoelectric conversion device and the fabrication method therefor according to the present embodiment, there is an advantage that a high photoelectric conversion efficiency is obtained in both of a low-illuminance indoor light environment (low-illuminance condition) and a high-illuminance solar light environment (high-illuminance condition). Further, with the fabrication method for the photoelectric conversion device according to the present embodiment, a photoelectric conversion device with which a high photoelectric conversion efficiency is obtained in both of a low-illuminance indoor light environment and a high-illuminance solar light environment can be fabricated easily.

It is to be noted that the present invention is not limited to the embodiment specifically described above, and variations and modifications can be made without departing from the spirit and scope of the present invention.

For example, while, in the embodiment described above, the drying step (drying process) is performed after the applying step (applying process), the present invention is not limited to this, and, for example, the applying step and the drying step may be performed in parallel by a single step. In particular, while, in the embodiment described above, the applied mixed liquid is dried in the step after the mixed liquid is applied, for example, applying and drying of mixed liquid may be performed in parallel by a single step.

Further, while the embodiment described above is described taking a case in which a photoelectric conversion device is used for an organic thin film type solar cell as an example, the embodiment is not limited to this, and, for example, a photoelectric conversion device can be used for a sensor of an image apparatus such as a camera.

### [EXAMPLES]

In the following, the present invention is described in more detail in connection with an example. It is to be noted that the present invention is not limited by the example described below.

In the present example, the photoelectric conversion device was fabricated in the following manner.

First, an ITO electrode (positive electrode) havingawidth of approximately 2 mm and a film thickness of approximately 200 nm was formed on a glass substrate.

Then, a MoO₃ layer (positive electrode side buffer layer) having a thickness of approximately 6 nm was formed by vacuum deposition on the overall area of the ITO electrode as the positive electrode.

Then, the glass substrate on which the ITO electrode and the MoO₃ layer were formed was placed into a globe box in which nitrogen was filled. Then, a film of monochlorobenzene solution (mixed solution; density: approximately 2 % by weight) including the PCDTBT as the p-type organic semiconductor material and the PCBM (here, [6,6]-phenyl-C₇₁ butyric acid methyl ester; hereinafter referred to as PC71BM) as the n-type organic semiconductor material by a weight ratio of 1:3 was formed, at approximately 25°C (room temperature), by spin coating under a condition of approximately 500 rpm. Then, the resulting intermediate product was dried.

Thereafter, at approximately 25°C, the dried intermediate product was left (exposed) in a saturation atmosphere including vapor of dichloromethane as a solvent that preferentially dissolves the n-type organic semiconductor material rather than the p-type organic semiconductor material. In short, a dichloromethane process (vapor process) was performed.

A photoelectric conversion layer having a thickness of approximately 80 nm was formed in this manner.

Then, a lithium fluoride (hole block layer) having a thickness of approximately 1 nm was formed on the photoelectric conversion layer formed and exposed in such a manner as described above without performing heat treatment.

Thereafter, an aluminum electrode (negative electrode) having a width of approximately 2 nm and a thickness of approximately 150 nm was formed by vacuum deposition on the lithium fluoride layer as the hole block layer.

Then, the intermediate product was encapsulated in a nitrogen atmosphere to fabricate a photoelectric conversion device.

Here, a plurality of photoelectric conversion devices (samples; film thickness of the photoelectric conversion layer: approximately 80 nm; subjected to the drying process at approximately 25°C) were fabricated changing the time period (dichloromethane processing time period) within which the intermediate product was to be left in a dichloromethane saturation atmosphere. The photoelectric conversion devices just described are hereinafter referred to as samples of an example 1. Further, a photoelectric conversion device was manufacture similarly to the samples of the example 1 described above but without performing the dichloromethane process. The photoelectric conversion device just described is hereinafter referred to as sample of an example 2. Further, a photoelectric conversion device in which the thickness of the photoelectric conversion layer was changed from that of the samples of the example 1 and set to approximately 170 nm, namely, a photoelectric conversion device in which the thickness of the photoelectric conversion layer was set to approximately 170 nm and for which the dichloromethane process was performed for approximately two minutes, was fabricated. The photoelectric conversion device just described is hereinafter referred to as sample of an example 3. Further, also a photoelectric conversion device in which the thickness of the photoelectric conversion layer was changed from that of the sample of the example 2 and set to approximately 170 nm, namely, a photoelectric conversion device in which the thickness of the photoelectric conversion layer was set to approximately 170 nm and for which the dichloromethane process was not performed, was fabricated. The photoelectric conversion device just described is hereinafter referred to as sample of an example 4. Further, a photoelectric conversion device was produced by performing the drying process at approximately 60°C in place of the drying process at approximately 25°C but without performing the dichloromethane process similarly to the samples of the example 1 described above. The photoelectric conversion device just described is hereinafter referred to as sample of a comparative example 1.

Here, FIG. 3 depicts a variation of a photoelectric conversion characteristic (JV characteristic; photoelectric conversion parameter) with respect to the dichloromethane process time period of each sample of the example 1 in a solar simulator having a radiation illuminance of 100 mW/cm². Further, FIG. 4 depicts a variation of a photoelectric conversion characteristic (JV characteristic; photoelectric conversion parameter) with respect to the dichloromethane process time period of each sample of the example 1 under white fluorescent lamp light of an illuminance of 390 Lx and a radiation illuminance of 90 µW/cm².

As depicted in FIGS. 3 and 4, the samples of the example 1 for which the dichloromethane process was performed (dichloromethane process time period: 1 to 6 minutes) indicate enhancement of the fill factor in comparison with that of the sample of the example 2 for which the dichloromethane process was not performed (dichloromethane process time period: 0 minute). Further, the short-circuit current density is maximized by the dichloromethane process time period of 2 minutes, and the samples of the example 1 for which the dichloromethane process was performed (dichloromethane process time period: 2 or 3 minutes) exhibit enhancement in short-circuit current density in comparison with the sample of the example 2 for which the dichloromethane process was not performed (dichloromethane process time period: 0 minute). As a result, the samples of the example 1 for which the dichloromethane process was performed (dichloromethane process time period: 1 to 4 minutes) exhibit enhancement in photoelectric conversion efficiency in comparison with the sample of the example 2 for which the dichloromethane process was not performed (dichloromethane process time period: 0 minute). In particular, the samples of the example 1 for which the dichloromethane process was performed (dichloromethane process time period: 1 to 4 minutes) exhibit enhancement in photoelectric conversion efficiency in comparison with the sample of the example 2 for which the dichloromethane process was not performed (dichloromethane process time period: 0 minute) in both of a low-illuminance indoor light environment (low-illuminance condition) and a high-illuminance solar light environment (high-illuminance condition). It is to be noted that, in the photoelectric conversion device fabricated in such a manner as in the example 1, it is preferable to set the time period for which the dichloromethane process (vapor process) is to be performed, for example, to approximately 4 minutes as an upper limit. This is because, if the dichloromethane process is performed for an excessively long time period, then formation of a phase separation structure excessively progresses and a domain becomes great to such a degree that it exceeds an diffusion length of excitons by a great amount, and as a result, the photoelectric conversion efficiency is degraded by a drop of the short-circuit current density. In particular, in comparison with a case in which the dichloromethane process is not performed, by performing the dichloromethane process (particularly, by performing the dichloromethane process to form the photoelectric conversion layer 4 having the stacked structure 4Z described above, namely, the photoelectric conversion layer 4 having a diffraction peak corresponding to a plane spacing d = 1. 6 nm to 2. 0 nm in an X-ray diffraction profile), the fill factor can be enhanced irrespective of the processing time period of the dichloromethane process. However, while the result of the process just described contributes to enhancement of the photoelectric conversion efficiency, if the dichloromethane process is performed for an excessively long time period, then a domain becomes excessively great exceeding the diffusion length of excitons and the short-circuit current density decreases. The decrease of the sort-circuit current density contributes to decrease of the photoelectric conversion efficiency, and as a result, the photoelectric conversion efficiency drops. It is to be noted that, while, in the photoelectric conversion device manufactured in such a manner as in the example 1, the enhancement of the photoelectric conversion efficiency is achieved in the case in which the time period for which the dichloromethane process is to be performed is set to a period up to approximately 4 minutes in comparison with an alternative case in which the dichloromethane process is not performed, if the condition such as, for example, the temperature or the density varies, then the photoelectric conversion efficiency can be enhanced also in a difference case in which the dichloromethane process is performed for a longer period of time.

Further, FIGS. 5(A) and 5(B) depict mapping images of electron energy loss spectroscopy (EELS) performed taking carbon nuclei and sulfur nuclei as a target for a cross section of a sample of the example 1 that is most superior in photoelectric conversion efficiency in the photoelectric conversion characteristic in the solar simulator described above and for which the dichloromethane process was performed for fourminutes. Here, FIG. 5(A) depicts a mapping image (EELS-C) obtained by performing cross-sectional analysis by the electron energy loss spectroscopy and mapping signals corresponding to carbon atoms. Meanwhile, FIG. 5(B) depicts a mapping image (EELS-S) obtained by performing cross-sectional analysis by the electron energy loss spectroscopy and mapping signals corresponding to sulfur atoms.

In the mapping image depicted in FIG. 5(A) in which carbon atoms are targeted, a region in which PC71BM is a main constituent and the density of carbon atoms is high looks white. On the other hand, in the mapping image depicted in FIG. 5(B) in which sulfur atoms are targeted, a region in which sulfur atoms included only in the PCDTBT exist looks white. Since the mapping image depicted in FIG. 5(A) in which carbon atoms are targeted and the mapping image depicted in FIG. 5(B) in which sulfur atoms are targeted have a complementary relationship to each other, it is recognized that the PC71BM as the n-type organic semiconductor material and the PCDTBT as the p-type organic semiconductor material are phase-separated in a size of approximately 20 to 30 nm.

In contrast, FIGS. 6 (A) and 6 (B) depict mapping images of the electron energy loss spectroscopy performed taking carbon atoms and sulfur atoms as a target for a cross section of the sample of the example 2 for which the dichloromethane process was not performed. Here, FIG. 6(A) depicts a mapping image (EELS-C) obtained by performing cross-sectional analysis by the electron energy loss spectroscopy and mapping signals corresponding to the carbon atoms. Further, FIG. 6(B) depicts a mapping image (EELS-S) obtained by performing cross-sectional analysis by the electron energy loss spectroscopy and mapping signals corresponding to the sulfur atoms.

As depicted in FIGS. 6(A) and 6(B), while a region (domain) in which the amount of the PCDTBT as the p-type organic semiconductor material is relatively great and another region (domain) in which the amount of the PC71BM as the n-type organic semiconductor material is relatively great are formed, it is recognized that the degree of development of the regions is low in comparison with that of the case [refer to FIGS. 5(A) and 5(B)] of the example 1 in which the dichloromethane process was performed.

Further, FIGS. 7(A), 7(B) and 7(C) depict images of the same region of a cross section of a sample same as a sample of the example 1 whose mapping images are depicted in FIGS. 5(A) and 5(B). More particularly, FIGS. 7(A), 7(B) and 7(C) depict a mapping image (EELS-C) by the electron energy loss spectroscopy taking carbon atoms as a target, a mapping image (EELS-S) by the electron energy loss spectroscopy taking sulfur atoms as a target, and a result (STEM image) of observation using a scanning transmission electron microscope (STEM) in an equal magnification, respectively. While, in the STEM image, a region in which the density is high is observed dark, if FIGS. 7(A) and 7(B) and FIG. 7(C) are compared with each other, then the contrast of the STEM image coincides accurately with that of the EELS mapping image. Therefore, it is recognized that a bright region is a region in which the amount of the PCDTBT is great and a dark region is a region in which the amount of the PC71BM is great, and a fine structure of a phase separation state can be observed indirectly from the STEM image. Here, a sectional STEM image depicted in FIG. 7(D) depicts, in an enlarged scale, a relatively bright region in which the amount of the PCDTBT is great. The STEM image indicates that a stripe pattern of a period of approximately 2 nm is observed and consequently, a stacked structure in which the PC71BM is inserted in the PCDTBT is formed. It is to be noted that the scale of the sectional STEM image of FIG. 7(D) is approximately 15 nm.

In contrast, FIG. 8 depicts a result (STEM image) when a cross section of a sample same as that of the example 2 whose mapping images are depicted in FIGS. 6 (A) and 6(B) is observed by a scanning transmission electron microscope (STEM).

The STEM image depicted in FIG. 8 indicates that neither a clear contrast nor an internal structure can be observed and a phase separation structure and a stacked structure on the order of nanometers are not yet developed to such a degree that they can be confirmed on the STEM image.

Further, FIG. 9 depicts X-ray diffraction profiles obtained by performing X-ray diffraction analysis for the sample of the example 1 for which the drying process was performed at approximately 25°C and then the dichloromethane process was performed for two minutes and the sample of the example 2 for which the drying process was performed at approximately 25°C but the dichloromethane process was not performed and then performing standardization using the film thickness. It is to be noted that, in FIG. 9, a solid line A indicates the X-ray diffraction profile of the photoelectric conversion layer provided in the sample of the example 1 for which the drying process was performed at approximately 25°C and then the dichloromethane process was performed for two minutes, and a solid line B indicates the X-ray diffraction profile of the photoelectric conversion layer provided in the sample of the example 2 for which the drying process was performed at approximately 25°C but the dichloromethane process was not performed.

It is to be noted here that the X-ray diffraction profiles are those obtained by scanning by a detector in an in-plane direction of the sample (namely, in a direction parallel to a film surface) at an incidence position of a very small angle and measuring a lattice plane perpendicular to the surface, and the wavelength of the X-ray is 1.54 Å and corresponds to CuKα. Further, since the film thickness of the photoelectric conversion layers of the samples has a variation, the X-ray diffraction profiles are in a state standardized with the thickness. Thus, the axis of ordinate of FIG. 9 indicates standardized diffraction strength. It is to be noted that, in FIG. 9, for comparison, the X-ray diffraction profile of the photoelectric conversion layer provided in the sample of the comparative example for which the drying process was performed at approximately 60°C in place of the drying process at approximately 25°C but the dichloromethane process was not performed is indicated by a solid line C, and X-ray diffraction profiles with regard to single films of the PCDTBT and the PC71BM are indicated by solid lines D and E.

Further, while both of the X-ray diffraction profiles with regard to simple films of the PCDTBT and the PC71BM individually have a diffraction peak as indicated by the solid line D and E in FIG. 9, the width of the peaks is approximately 3° to 5° and very broad. This indicates that both of the PCDTBT and PC71BM are amorphous materials both having low crystallinity and a structure order only on the order of several nm. It is to be noted that, as indicated by the solid line D in FIG. 9, it is recognized that the X-ray diffraction profile with regard to the single film of the PCDTBT has peaks at each of 2θ = 4° and 20°. The diffraction peaks of the PCDTBT are peaks arising from the lamella structure of the polymer and indicate that a lamella structure having a high degree of planarity is not formed because of a twist structure of molecules of the PCDTBT. Further, it is recognized that, as indicated by the solid line E in FIG. 9, the X-ray diffraction profile with regard to the single film of the PC71BM has peaks at each of 2θ = 9°, 18.5° and 27.5°. The diffraction peaks of the PC71BM are peaks reflecting the distance between molecules of C70 fullerene, and the peak at 2θ = 9° corresponds to a primary peak while the peaks at 29 = 18.5° and 27.5° correspond to secondary and tertiary peaks, respectively. Further, as indicated by the solid lines A to C in FIG. 9, in the X-ray diffraction profiles of the photoelectric conversion layer of the samples of the examples 1 and 2 and the comparative example 1 in which the PCDTBT and the PC71BM were mixed to form the photoelectric conversion layer, peaks can be confirmed in the proximity of 2θ=9°, 18.5 ° and 27.5°. Therefore, it is recognized that the contribution of the PC71BM is high. Especially, the peak at 2θ = 18.5 that is an aggregate of peaks arising from various orientation planes of the PC71BM is intensified by performing the dichloromethane process as indicated by the solid lines A to C in FIG. 9. This fact indicates that the phase separation progressed by performing the dichloromethane process and the domain of the PC71BM grew. It is to be noted that a plane spacing is referred to also as inter-plane spacing.

Particularly, as indicated by the solid lines A and B in FIG. 9, in the X-ray diffraction profiles of the photoelectric conversion layer of the samples of the examples 1 and 2, a peak that is not observed in the X-ray diffraction profiles of the PCDTBT and the PC71BM of single films exists at 2θ = 4° to 5° (refer to a location indicated by an arrow mark X in FIG. 9).

Here, FIG. 10 depicts profiles obtained by re-plotting the X-ray diffraction profiles depicted in FIG. 9 taking the plane spacing d between diffraction planes which can be calculated in accordance with the Bragg diffraction conditional expression 2dsinθ = A as the axis of abscissa. It is to be noted that, in FIG. 10, a solid line A indicates the X-ray diffraction profile of the photoelectric conversion layer of the sample of the example 1; a solid line B the X-ray diffraction profile of the photoelectric conversion layer of the sample of the example 2; a solid line C the X-ray diffraction profile of the photoelectric conversion layer of the sample of the comparative example 1; a solid line D the X-ray diffraction profile of the photoelectric conversion layer of the PCDTBT of a single film; and a solid line E the X-ray diffraction profile of the photoelectric conversion layer of the PC71BM of a single film.

As depicted in FIG. 10, it is recognized that a peak existing at 2θ = 4 to 5° in the X-ray diffraction profiles of the photoelectric conversion layer of the samples of the examples 1 and 2 corresponds to a peak existing at a plane spacing d = 1.6 nm to 2.0 nm, namely, a peak corresponding to the structure of the plane spacing d = 1.6 nm to 2.0 nm (refer to a region denoted by reference character X in FIG. 10). This peak indicates that, since the PCDTBT and the PC71BM are amorphous, the two materials are mixed on the level of molecules in an interface region therebetween and an ordered structure having a period different from that where the materials individually exist as a simple substance, namely, a stacked structure, is formed by an interaction between the molecules of the materials. It is to be noted here that, while a case is described as an example in which the PCDTBT is used as the p-type organic semiconductor material and the PC71BM is used as the n-type organic semiconductor material, this similarly applies also to a case in which the p-type organic semiconductor materials and the n-type organic semiconductor materials given as examples in the embodiment described above are used. In this manner, arising from the stacked structure that is provided in the p-type organic semiconductor region of the photoelectric conversion layer and in which the n-type organic semiconductor material and the p-type organic semiconductor material are stacked alternately, a diffraction peak corresponding to the plane spacing d = 1.6 nm to 2.0 nm appears in the X-ray diffraction profiles. Therefore, the photoelectric conversion layer has a diffraction peak corresponding to the plane spacing d = 1.6 nm to 2.0 nm in its X-ray diffraction profile.

On the other hand, as indicated by the solid line C in FIGS. 9 and 10, a peak little exists at 2θ = 4° to 5°, namely, at the plane spacing d = 1.6 nm to 2.0 nm, in the sample of the comparative example 1 for which the drying process was performed at approximately 60°C but the dichloromethane process was not performed.

In this manner, while, in the sample of the comparative example 1, a peak little exists at 2θ = 4° to 5°, namely, at the plane spacing d = 1.6 nm to 2.0 nm, in the sample of the example 2, a peak exists at 2θ = 4 to 5°, namely, at the plane spacing d = 1.6 nm to 2.0 nm as indicated by the solid line B in FIGS. 9 and 10. In particular, by performing the drying process at 25°C in place of the drying process at approximately 60°C, a peak appears at 2θ = 4° to 5°, namely, at the plane spacing d = 1.6 nm to 2.0 nm. This indicates that the stacked structure described above is formed by performing the drying process, for example, at a lower temperature than approximately 60°C.

Then, the peak existing at 2θ = 4° to 5°, namely, at the plane spacing d = 1.6 nm to 2.0 nm, in the sample of the example 2 is observed more intensely and clearly on the samples of the example 1. In particular, by performing the drying process at approximately 25 °C and further performing the dichloromethane process, the peak appearing at 2θ = 4 to 5°, namely, at the peak appearing in the plane spacing d = 1.6 nm to 2.0 nm, appears more intensely and clearly. This indicates that, by performing the drying process, for example, at a lower temperature than approximately 60°C and further performing the dichloromethane process (vapor process), the stacked structure described above is developed.

Further, as indicated by the solid lines A and B in FIGS. 9 and 10, a shoulder-shaped peak exists in the proximity of 28 = 9° in the X-ray diffraction profiles of the samples of the examples 1 and 2 (refer to a location indicated by an arrow mark Y in FIGS. 9 and 10). While, in the sample of the example 2, a shoulder-shaped peak exists at a position corresponding to a plane spacing d = 1.1 nm, in the samples of the example 1, a shoulder-shaped peak exists at a position corresponding to a different plane spacing d = 1.0 nm. In particular, by performing the dichloromethane process, the shoulder-shaped peak shifts and the plane spacing decreases from 1.1 nm to 1.0 nm. The shoulder-shaped peak is peak reflecting the inter-molecule distance of C70 fullerene and is a result of synthesis of a peak originating from the (111) plane (corresponding to the plane spacing d = 0.89 nm) and another peak originating from the (11-1) plane (corresponding to the plane spacing d = 1.07 nm) of the PC71BM. If only the PC71BM is involved, then a peak appears at a position of 0.95 nm corresponding to a plane spacing d between 1.07 nm and 0.89 nm. Therefore, that the shoulder-shaped peak shifts and the plane spacing d decreases from 1.1 nm to 1.0 nm indicates that the arrangement state of the PC71BM is improved by performing the dichloromethane process, namely, re-arrangement of the PC71BM proceeds and the structure regularity in the domain of the PC71BM approaches an original one of the PC71BM.

Further, FIG. 11 depicts a result when the integrated intensity at a portion, which corresponds to the plane spacing d = 1. 6 nm to 2.0 nm, in the X-ray diffraction profiles depicted in FIGS. 9 and 10 is plotted in a relationship with the photoelectric conversion efficiency under white fluorescent lamp light (illuminance: 390 Lx, radiation illuminance: 90 µW/cm²).

As depicted in FIG. 11, it is recognized that the photoelectric conversion efficiency enhances as the integrated intensity at a portion corresponding to the place distance d = 1.6 nm to 2.0 nm increases. In particular, it is recognized that the photoelectric conversion efficiency enhances with the sample of the example 2 indicated by reference character B in FIG. 11 in comparison with the sample of the comparative example 1 depicted by reference character C in FIG. 11 and the photoelectric conversion efficiency enhances with the sample of the example 1 indicated by reference character A in FIG. 11 in comparison with the sample of the example 2 depicted by reference character B in FIG. 11. In this manner, it is recognized that, by performing the drying process, for example, at a lower temperature than approximately 60 °C, the photoelectric conversion efficiency enhances and, by further performing the dichloromethane process, the photoelectric conversion efficiency enhances further. This signifies that, by forming the stacked structure by an interaction of molecules of the PCDTBT and the PC71BM, the transportability of the carriers enhances and the charge separation efficiency and the photoelectric conversion efficiency enhance. Especially, it is recognized that, with the sample of the example 1 for which the drying process was performed, for example, at a lower temperature than approximately 60°C and further performing the dichloromethane process, the conversion efficiency exceeds 18 % and exceeds the photoelectric conversion efficiency (approximately 17 %) under the same condition of an a-Si solar cell indicated by a broken line X in FIG. 11.

FIG. 12 depicts I-V curves in a solar simulator (radiation illuminance: 100 mW/cm²) of the sample of the example 1 (dichloromethane process time period: two minutes; film thickness: approximately 80 nm) and the sample of the example 2 (no dichloromethane process; film thickness: approximately 80 nm).

As depicted in FIG. 12, under a high-illuminance condition in the solar simulator, the I-V curve with regard to the sample of the example 1 is such as indicated by a broken line A in FIG. 12, and the I-V curve with regard to the sample of the example 2 is such as indicated by a solid line B in FIG. 12. In particular, in the sample of the example 1, the open voltage (Voc) was approximately 0.839 V; the short-circuit current density (Jsc) was approximately 8.74 mA/cm²; the fill factor (FF) approximately 0.55; and the photoelectric conversion efficiency approximately 4.0 %. On the other hand, in the sample of the example 2, the open voltage (Voc) was approximately 0.910 V; the short-circuit current density (Jsc) approximately 8.28 mA/cm²; the fill factor (FF) approximately 0.43; and the photoelectric conversion efficiency approximately 3.2 %. It is to be noted that the photoelectric conversion efficiency can be calculated in accordance with an expression of the photoelectric conversion efficiency = (Voc × Jsc × FF) / (radiation illuminance of incident light × 100. In this manner, in the sample of the example 1, the short-circuit current density (Jsc) and the fill factor (FF) enhanced in comparison with the sample of the example 2, and as a result, the photoelectric conversion efficiency enhanced. In other words, by performing the dichloromethane process for two minutes, the short-circuit current density (Jsc) and the fill factor (FF) enhanced, and as a result, the photoelectric conversion efficiency enhanced.

FIG. 13 depicts I-V curves under white fluorescent lamp light (illuminance: 390 Lx, radiation illuminance: 90 µW/cm²) of the sample of the example 1 (dichloromethane process time period: two minutes; film thickness: approximately 80 nm) and the sample of the example 2 (no dichloromethane process; film thickness: approximately 80 nm).

As depicted in FIG. 13, under white fluorescent lamp light, namely, under a low-illuminance condition, the I-V curve with regard to the sample of the example 1 was such as indicated by a broken line A in FIG. 13 and the I-V curve of the sample with regard to the example 2 was such as indicated by a solid line B in FIG. 13. In particular, in the sample of the example 1, the open voltage (Voc) was approximately 0.706 V; the short-circuit current density (Jsc) approximately 28.4 µA/cm²; the fill factor (FF) approximately 0.71; the maximum power density (Pmax) approximately 14. 3 µW/cm²; and the photoelectric conversion efficiency approximately 16 %. On the other hand, in the sample of the example 2, the open voltage (Voc) was approximately 0.776 V; the short-circuit current density (Jsc) approximately 27.2 µA/cm²; the fill factor (FF) approximately 0.64; the maximum power density (Pmax) approximately 13.0 µW/cm²; and the photoelectric conversion efficiency approximately 14 %. It is to be noted that the fill factor is defined by (Pmax) / (Voc × Jsc). In this manner, with the sample of the example 1, the short-circuit current density (Jsc) and the fill factor (FF) enhanced in comparison with the sample of the example 2, and as a result, the photoelectric conversion efficiency enhanced. In particular, by performing the dichloromethane process for two minutes, the short-circuit current density (Jsc) and the fill factor (FF) enhanced, and as a result, the photoelectric conversion efficiency enhanced.

By performing the dichloromethane process for two minutes in this manner, the short-circuit current density (Jsc) and the fill factor (FF) enhanced in both of a high-illuminance condition and a low-illuminance condition, and as a result, the photoelectric conversion efficiency enhanced. Further, FIG. 14 depicts I-V curves in the solar simulator (radiation illuminance: 100 mW/cm²) of the sample of the example 3 (dichloromethane process time period: two minutes; film thickness: approximately 170 nm) and the sample of the example 4 (no dichloromethane process; film thickness: approximately 170 nm).

As depicted in FIG. 14, under a high-illuminance condition in the solar simulator, the I-V curve with regard to the sample of the example 3 was such as indicated by a broken line A in FIG. 14 and the I-V curve with regard to the sample of the example 4 was such as indicated by a solid line B in FIG. 14. In particular, in the sample of the example 3, the open voltage (Voc) was approximately 0.882 V; the short-circuit current density (Jsc) approximately 10.55 mA/cm²; the fill factor (FF) approximately 0.45; and the photoelectric conversion efficiency approximately 4.2%. On the other hand, in the sample of the example 4, the open voltage (Voc) was approximately 0. 861 V; the short-circuit current density (Jsc) approximately 6.19 mA/cm²; the fill factor (FF) approximately 0.38; and the photoelectric conversion efficiency approximately 2.0 %. In this manner, with the sample of the example 3, the short-circuit current density (Jsc) and the fill factor (FF) enhanced in comparison with the sample of the example 4, and as a result, the photoelectric conversion efficiency enhanced. In short, even where the photoelectric conversion layer was formed with an increased film thickness, by performing the dichloromethane process for two minutes, the short-circuit current density (Jsc) and the fill factor (FF) enhanced, and as a result, the photoelectric conversion efficiency enhanced.

FIG. 15 depicts I-V curves under white fluorescent lamp light (illuminance: 390 Lx, radiation illuminance: 90 µW/cm²) of the sample of the example 3 (dichloromethane process time period: two minutes; film thickness: approximately 170 nm) and the sample of the example 4 (no dichloromethane process; film thickness: approximately 170 nm).

As depicted in FIG. 15, under white fluorescent lamp light, namely, under a low-illuminance condition, the I-V curve with regard to the sample of the example 3 is such as indicated by a broken line A in FIG. 15 and the I-V curve with regard to the sample of the example 4 is such as indicated by a solid line B in FIG. 15. In particular, with the sample of the example 3, the open voltage (Voc) was approximately 0.742 V; the short-circuit current density (Jsc) approximately 34 µA/cm²; the fill factor (FF) approximately 0.72; the maximum power density (Pmax) approximately 18.1 µW/cm²; and the photoelectric conversion efficiency approximately 20 %. On the other hand, with the sample of the example 4, the open voltage (Voc) was approximately 0.754 V; the short-circuit current density (Jsc) approximately 27.7 µA/cm² ; the fill factor (FF) approximately 0.58; the maximumpower density (Pmax) approximately 12.1 µW/cm²; and the photoelectric conversion efficiency approximately 13 %. In this manner, with the sample of the example 3, the short-circuit current density (Jsc) and the fill factor (FF) enhanced in comparison with the sample of the example 4, and as a result, the photoelectric conversion efficiency enhanced. In particular, by performing the dichloromethane process for two minutes, the short-circuit current density (Jsc) and the fill factor (FF) enhanced, and as a result, the photoelectric conversion efficiency enhanced.

In this manner, by performing the dichloromethane process for two minutes, also where the thickness of the photoelectric conversion layer was increased, the short-circuit current density (Jsc) and the fill factor (FF) enhanced in both of a high-illuminance condition and a low-illuminance condition, and as a result, the photoelectric conversion efficiency enhanced.

Further, FIG. 16 depicts I-V curves in the solar simulator (radiation illuminance: 100 mW/cm²) of the sample of the example 1 (dichloromethane process time period: two minutes; film thickness: approximately 80 nm) and the sample of the example 3 (dichloromethane process time period: two minutes; film thickness: approximately 170 nm).

As depicted in FIG. 16, under a high-illuminance condition in the solar simulator, the I-V curve with regard to the sample of the example 1 is such as indicated by a broken line A in FIG. 16 a and the I-V curve with regard to the sample of the example 3 is such as indicated by a solid line B in FIG. 16. In particular, in the sample of the example 1, the open voltage (Voc) was approximately 0.839 V; the short-circuit current density (Jsc) approximately 8.74 mA/cm²; the fill factor (FF) approximately 0.55; and the photoelectric conversion efficiency approximately 4.0 %. On the other hand, in the sample of the example 3, the open voltage (Voc) was approximately 0. 882 V; the short-circuit current density (Jsc) approximately 10.6 mA/cm²; the fill factor (FF) approximately 0.45; and the photoelectric conversion efficiency approximately 4.2 %. In this manner, in the sample of the example 3, although the fill factor (FF) deteriorated, since the short-circuit current density (Jsc) enhanced, the photoelectric conversion efficiency enhanced in comparison with the sample of the example 1. In short, by increasing the thickness of the photoelectric conversion layer, although the fill factor (FF) deteriorated, since the short-circuit current density (Jsc) enhanced, the photoelectric conversion efficiency enhanced.

FIG. 17 depicts I-V curves under white fluorescent lamp light (illuminance: 390 Lx, radiation illuminance: 90 µW/cm²) of the sample of the example 1 (dichloromethane process time period: two minutes; film thickness: approximately 80 nm) and the sample of the example 3 (dichloromethane process time period: two minutes; film thickness: approximately 170 nm).

As depicted in FIG. 17, under white fluorescent lamp light, namely, under a low-illuminance condition, the I-V curve of the sample of the example 1 is such as indicated by a broken line A in FIG. 17 and the I-V curve of the sample of the example 3 is such as indicated by a solid line B in FIG. 17. In particular, in the sample of the example 1, the open voltage (Voc) was approximately 0.706 V; the short-circuit current density (Jsc) approximately 28.4 µA/cm²; the fill factor (FF) approximately 0.71; the maximum power density (Pmax) approximately 14.3 µW/cm²; and the photoelectric conversion efficiency approximately 16 %. On the other hand, in the sample of the example 3, the open voltage (Voc) was approximately 0.742 V; the short-circuit current density (Jsc) approximately 34 µA/cm²; the fill factor (FF) approximately 0.72; the maximum power density (Pmax) approximately 18.1 µW/cm²; and the photoelectric conversion efficiency approximately 20 %. In this manner, in the sample of the example 3, in comparison with the sample of the example 1, while the fill factor (FF) does not dropped, the short-circuit current density (Jsc) enhanced, and as a result, the photoelectric conversion efficiency enhanced. In other words, even if the thickness of the photoelectric conversion layer was increased, the fill factor (FF) did not drop, and the increase of the film thickness of the photoelectric conversion layer was reflected as it was to enhance the short-circuit current density (Jsc), and as a result, the photoelectric conversion efficiency enhanced.

In this manner, even if the thickness of the photoelectric conversion layer was increased, the short-circuit current density (Jsc) enhanced without a drop of the fill factor (FF) under both of a high-illuminance condition and a low-illuminance condition, and as a result, the photoelectric conversion efficiency enhanced.

### REFERENCE SIGNS LIST

- 1: substrate (transparent substrate)
- 2: positive electrode (transparent electrode)
- 3: positive electrode side buffer layer
- 4: photoelectric conversion layer
- 4A: p-type organic semiconductor material (PCDTBT)
- 4B: n-type organic semiconductor material (PCBM)
- 4X: n-type organic semiconductor region
- 4Y: p-type organic semiconductor region
- 4Z: stacked structure
- 5: negative electrode side buffer layer (or hole block layer)
- 6: negative electrode (metal electrode)

## Claims

1. A photoelectric conversion device, comprising:
a positive electrode;
a negative electrode; and
a photoelectric conversion layer including a p-type organic semiconductor material and an n-type organic semiconductor material that configure a bulk heterojunction, including an amorphous polymer compound including a carbazole ring, a fluorene ring or a cyclopentadithiopene ring in a main chain as the p-type organic semi conductor material, and including an amorphous fullerene derivative as the n-type organic semiconductor material; wherein
the photoelectric conversion layer has a diffraction peak corresponding to a plane spacing d = 1.6 nm to 2.0 nm in an X-ray diffraction profile.

2. The photoelectric conversion device according to claim 1, wherein the photoelectric conversion layer has an n-type organic semiconductor region configured mainly from the n-type organic semiconductor material and a p-type organic semiconductor region configured mainly from the p-type organic semiconductor material, and the p-type organic semiconductor region has a stacked structure in which the n-type organic semiconductor material and the p-type organic semiconductor material are stacked alternately.

3. The photoelectric conversion device according to claim 2, wherein, in the n-type organic semiconductor region, the n-type organic semiconductor material has a substantially spherical aggregate shape.

4. The photoelectric conversion device according to any one of claims 1 to 3, wherein the photoelectric conversion layer includes, as the n-type organic semiconductor material, any one material selected from the group consisting of [6,6]-phenyl-C₇₁ butyric acid methyl ester, [6,5]-phenyl-C₆₁ butyric acid methyl ester, [6,6]-Phenyl-C₈₅ butyric acid methyl ester, indene-C60 bisadduct, [6,6] diphenyl C₆₂bis (butyric acid methyl ester), [6, 6] diphenyl C₇₂bis (butyric acid methyl ester), [6,6]-phenyl-C₆₁ butyric acid (3-ethylthiophene) ester, 1-(3-methoxycarbonyl)propyl-1-thienyl-6,6-methanofullerene, and [6,6]-phenyl-C₆₁ butyric acid (2,5-dibromo-3-ethylthiophene) ester; and
as the p-type organic semiconductor material, any one material selected from the group consisting of poly-[N-9'-heptadecanyl-2,7-carbazole-alt-5,5-(4',7'-di-2-t hienyl-2',1',3'-benzothiadiazole)], poly[(9,9-dioctylfluorenyl-2,7-diyl)-alt-co-(1,4-benzo-{2,1 ',3}-thiadiazole)], poly[(9,9-dihexylfluoreny-2,7-diyl)-alt-co-(bithophene)], poly[2,6-(4,4-bis-(2-ethylhexyl)-4H-cyclopenta[2,1-b;3,4-b' ]-dithiophene)-alt-4,7-(2,1,3-benzothiadiazole)], poly[2,7-(9-(2'-ethykhexyl)-9-hexyl-fluorene)-alt-5,5-(4'-7 '-di-2-thienyl-2',1',3"-benzothiadiazole], and poly[2,7-(9,9)-dioctylfluorene]-alt-5,5-(4',7'-di-2-thienyl -2',1',3'-benzothiadiazole).

5. The photoelectric conversion device according to any one of claims 1 to 4, wherein the photoelectric conversion layer, in the X-ray diffraction profile, has a diffraction peak between a diffraction peak corresponding to a (111) plane and a diffraction peak corresponding to a (11-1) plane in an X-ray diffraction profile of a simple substance of the n-type organic semiconductor material.

6. The photoelectric conversion device according to any one of claims 1 to 5, further comprising a positive electrode side buffer layer provided between the photoelectric conversion layer and the positive electrode and including a material having energy of the lowest unoccupied electron orbit shallower than that of the n-type organic semiconductor material and energy of the highest occupied electron orbit shallower than that of the p-type organic semiconductor material.

7. The photoelectric conversion device according to any one of claims 1 to 6, further comprising a negative electrode side buffer layer provided between the photoelectric conversion layer and the negative electrode and including a material having energy of the highest occupied electron orbit deeper than that of the p-type organic semiconductor material and energy of the lowest unoccupied electron orbit deeper than that of the n-type organic semiconductor material.

8. The photoelectric conversion device according to any one of claims 1 to 6, further comprising a hole block layer including lithium fluoride provided between the photoelectric conversion layer and the negative electrode.

9. A fabrication method for a photoelectric conversion device, comprising:
applying and drying mixed liquid including an amorphous polymer compound including a carbazole ring, a fluorene ring or a cyclopentadithiopene ring in a main chain as a p-type organic semiconductor material and an amorphous fullerene derivative as an n-type organic semiconductor material, the p-type organic semiconductor material and the n-type organic semiconductor material configuring a bulk heterojunction;
exposing the dried substance into an atmosphere including vapor of a solvent that preferentially dissolves the n-type organic semiconductor material rather than the p-type organic semiconductor material; and
forming a photoelectric conversion layer having a diffraction peak corresponding to a plane spacing d = 1.6 nm to 2.0 nm in an X-ray diffraction profile.

10. The fabrication method for a photoelectric conversion device according to claim 9, wherein the photoelectric conversion layer includes, as the n-type organic semiconductor material, any one material selected from the group consisting of [6,6]-phenyl-C₇₁ butyric acid methyl ester, [6, 6]-phenyl-C₆₁ butyric acid methyl ester, [6, 6] -Phenyl-C₈₅ butyric acid methyl ester, indene-C 60 bisadduct, [6, 6] diphenyl C₆₂bis (butyric acid methyl ester), [6, 6] diphenyl C₇₂bis (butyric acid methyl ester), [6,6]-phenyl-C₆₁ butyric acid (3-ethylthiophene) ester, 1-(3-methoxycarbonyl)propyl-1-thienyl-6,6-methanofullerene, and [6,6]-phenyl-C₆₁ butyric acid (2,5-dibromo-3-ethylthiophene) ester; and
as the p-type organic semiconductor material, any one material selected from the group consisting of poly-[N-9'-heptadecanyl-2,7-carbazole-alt-5,5-(4',7'-di-2-t hienyl-2',1',3'-benzothiadiazole)], poly[(9,9-dioctylfluorenyl-2,7-diyl)-alt-co-(1,4-benzo-{2,1 ',3}-thiadiazole)], poly[(9,9-dihexylfluoreny-2,7-diyl)-alt-co-(bithophene)], poly[2,6-(4,4-bis-(2-ethylhexyl)-4H-cyclopenta[2,1-b;3,4-b' ]-dithiophene)-alt-4,7-(2,1,3-benzothiadiazole)], poly[2,7-(9-(2'-ethykhexyl)-9-hexyl-fluorene)-alt-5,5-(4'-7 '-di-2-thienyl-2',1',3'-benzothiadiazole], and poly[2,7-(9,9)-dioctylfluorene]-alt-5,5-(4',7'-di-2-thienyl -2',1',3'-benzothiadiazole).

11. The fabrication method for a photoelectric conversion device according to claim 9 or 10, wherein the photoelectric conversion layer, in the X-ray diffraction profile, has a diffraction peak between a diffraction peak corresponding to a (111) plane and a diffraction peak corresponding to a (11-1) plane in an X-ray diffraction profile of a simple substance of the n-type organic semiconductor material.
